(19)

Europäisches
Patentamt
European
Patent Office
Office européen
des brevets

(11)  **EP 4 636 901 A1**

(12) **EUROPEAN PATENT APPLICATION**

(43) Date of publication:
**22.10.2025 Bulletin 2025/43**

(21) Application number: **24219636.8**

(22) Date of filing: **13.12.2024**

(51) International Patent Classification (IPC):
**H01M 10/42** $^{(2006.01)}$       **G01R 31/327** $^{(2006.01)}$
**H01M 10/623** $^{(2014.01)}$

(52) Cooperative Patent Classification (CPC):
**H01M 10/4257; H01M 10/623;** G01R 31/3842;
G01R 31/389

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.04.2024   CN 202410455102
25.10.2024   CN 202411507861
25.10.2024   CN 202411504843
25.10.2024   CN 202411509221
25.10.2024   CN 202411507849**

(71) Applicant: **Nanjing Chervon Industry Co., Ltd.
Nanjing, Jiangsu 211106 (CN)**

(72) Inventors:
• **JI, Yongchao**
  **Nanjing (CN)**
• **LIU, Weixuan**
  **Nanjing (CN)**
• **CAO, Yihan**
  **Nanjing (CN)**
• **YUAN, Yongjie**
  **Nanjing (CN)**
• **WEI, Junyu**
  **Nanjing (CN)**

(74) Representative: **Sun, Yiming
HUASUN Patent- und Rechtsanwälte
Friedrichstraße 33
80801 München (DE)**

(54) **METHOD FOR ESTIMATING A RELATIVE STATE OF CHARGE OF A BATTERY PACK AND
ELECTRICAL DEVICE SYSTEM**

(57)     Provided is a method for estimating a relative state of charge (RSoC) of a battery pack. The battery pack includes a housing, multiple cells, a power tool interface, and a first circuit board electrically connected to the power tool interface, where a first controller is disposed on the first circuit board. The estimation method includes: acquiring the voltage and the current of the battery pack through a detection assembly; determining the current depth of discharge (DoD) of the battery pack based on the voltage and the current of the battery pack; determining the endpoint DoD of the battery pack in the current working condition based on the voltage, the current, and the current DoD of the battery pack; and calculating the RSoC of the battery pack in the current working condition according to the current DoD and the endpoint DoD.

**EP 4 636 901 A1**

## Description

### RELATED APPLICATION INFORMATION

The present application claims the benefit under 35 U.S.C. §119(a) of Chinese Patent Application No. 202410455102.6, filed on Apr. 15, 2024, Chinese Patent Application No. 202411507849.8, filed on Oct. 25, 2024, Chinese Patent Application No. 202411507861.9, filed on Oct. 25, 2024, Chinese Patent Application No. 202411509221.1, filed on Oct. 25, 2024, and Chinese Patent Application No. 202411504843.5, filed on Oct. 25, 2024, which applications are incorporated herein by reference in their entirety.

### TECHNICAL FIELD

The present application relates to the technical field of power tools and, in particular, to a method for estimating a state of charge (SoC) of a battery pack.

### BACKGROUND

Battery packs in power tools have various capacities based on the battery type, the number of cells, and the SoH of the battery. At the same time, the charge/discharge speed and power of the battery pack vary based on the battery pack capacity, load size, charger characteristics, and usage environment. When using some electrical devices such as power tools, users may find that even if the state of charge (SoC) is not 0, the electrical devices can no longer draw current from the battery pack. In particular, when some power tools with high current discharge, such as chainsaws and snow throwers, are used, the normal SoC of the battery cannot be 0 through discharging. Therefore, the SoC with the conventional definition may sometimes cause confusion or trouble to the users, making it impossible for the users to reasonably evaluate the power requirements of the electrical devices that need to be used such as power tools.

When the power of the battery pack is not fully used, it is likely to affect the feel of the power tool. When the power of the battery pack is overused, an adverse effect on the health of the battery pack exists, which is even detrimental to the safe usage of the battery pack.

During the aging process of the battery, the capacity gradually decreases and the internal resistance slowly increases. In the conventional method, the battery is fully charged and/or discharged so that the maximum charge/discharge capacity, that is, the maximum chemical capacity, of the battery during a complete charge and/or discharge cycle can be acquired. In the conventional method, a stable current during the complete charge and/or discharge cycle is usually required, and the experimental conditions are relatively harsh and may not always be satisfied during the daily use of the users.

Different charge/discharge speeds and powers of battery packs limit the accurate estimation of the completion time of the battery packs being charged and discharged, which is not conducive to improving the user experience.

This part provides background information related to the present application, and the background information is not necessarily the existing art.

### SUMMARY

An object of the present application is to solve or at least alleviate part or all of the preceding problems. Therefore, an object of the present application is to provide a method for estimating a relative SoC (RSoC) of a battery pack and an electrical device system.

To achieve the preceding object, the present application adopts the technical solutions below.

The present application provides a method for estimating an RSoC of a battery pack. The battery pack includes a housing, multiple cells accommodated in the housing, a power tool interface disposed on the housing, and a first circuit board accommodated in the housing and electrically connected to the power tool interface, where a first controller is disposed on the first circuit board. The estimation method includes: acquiring the voltage and the current of the battery pack through a detection assembly; determining the current depth of discharge (DoD) of the battery pack based on the voltage and the current of the battery pack; determining the endpoint DoD of the battery pack in the current working condition based on the voltage, the current, and the current DoD of the battery pack; and calculating the RSoC of the battery pack in the current working condition according to the current DoD and the endpoint DoD.

In an example, the step of determining the current DoD of the battery pack based on the voltage and the current of the battery pack includes: calculating the initial DoD based on the voltage of the battery pack at rest, and calculating the current DoD based on the initial DoD, the maximum chemical capacity, and the current of the battery pack.

In an example, the maximum chemical capacity is determined based on the initial chemical capacity and the overall SoH of the battery pack.

In an example, a moment when the voltage of the battery pack reaches the discharge cut-off voltage is defined as a discharge endpoint, and the endpoint DoD is defined as the DoD corresponding to the voltage at the discharge endpoint.

In an example, the step of determining the endpoint DoD of the battery pack in the current working condition based on the voltage, the current, and the current DoD of the battery pack includes: adaptively learning an impedance curve in the current working condition based on the voltage, the current, and the current DoD of the battery pack; determining a voltage variation curve of the battery pack in the current working condition according to the impedance curve and the current DoD; and determining the endpoint DoD according to the voltage variation curve and the discharge cut-off voltage.

In an example, the step of adaptively learning the impedance curve in the current working condition based on the voltage, the current, and the current DoD of the battery pack includes: based on the voltage and the current of the battery pack, calculating impedance information of the battery pack corresponding to the current DoD; and updating the impedance curve based on the impedance information and temperature information.

In an example, the RSoC is the ratio of the difference between the endpoint DoD and the current DoD to the endpoint DoD.

The present application provides a method for estimating an RSoC of a battery pack. The battery pack includes a housing, multiple cells accommodated in the housing, a power tool interface disposed on the housing, and a first circuit board accommodated in the housing and electrically connected to the power tool interface, where a first controller is disposed on the first circuit board. The estimation method includes: acquiring the voltage and the current of the battery pack through a detection assembly; acquiring the accumulated discharge capacity of the battery pack based on the voltage and the current of the battery pack; acquiring the maximum discharge capacity of the battery pack in the current working condition based on the voltage and the current of the battery pack; and calculating the RSoC of the battery pack in the current working condition according to the accumulated discharge capacity and the maximum discharge capacity.

In an example, the accumulated discharge capacity is the product of the maximum chemical capacity of the battery pack and the current DoD of the battery pack.

In an example, the maximum discharge capacity is the product of the maximum chemical capacity of the battery pack and the endpoint DoD of the battery pack in the current working condition.

In an example, the RSoC is the ratio of the difference between the maximum discharge capacity and the accumulated discharge capacity to the maximum discharge capacity.

The present application further provides an electrical device system. The electrical device system includes: a battery pack including a housing, multiple cells accommodated in the housing, a power tool interface disposed on the housing, and a first circuit board accommodated in the housing and electrically connected to the power tool interface, where a first controller is disposed on the first circuit board; a body including a body housing, a battery pack interface disposed on the body housing and used for connecting the power tool interface, and a second circuit board accommodated in the body housing and electrically connected to the battery pack interface, where a second controller is disposed on the second circuit board; and a detection assembly for detecting at least the voltage and the current of the battery pack, where the detection assembly is disposed in the housing of the battery pack and/or the body housing of the body. The first controller or the second controller is communicatively connected to the detection assembly and is configured to: acquire the voltage and the current of the battery pack through the detection assembly; calculate the current DoD of the battery pack based on the voltage and the current of the battery pack; determine the endpoint DoD of the battery pack in the current working condition based on the voltage, the current, and the current DoD of the battery pack; and determine the SoC of the battery pack and the RSoC of the battery pack in the current working condition according to the current DoD and the endpoint DoD.

In an example, the RSoC is the ratio of the difference between the endpoint DoD and the current DoD to the endpoint DoD, and the SoC is the difference between 1 and the current DoD.

In an example, the step of determining the current DoD of the battery pack includes: calculating the initial DoD based on the voltage of the battery pack at rest and calculating the current DoD based on the initial DoD, the maximum chemical capacity, and the current of the battery pack.

In an example, the maximum chemical capacity is determined based on the initial chemical capacity and the overall SoH of the battery pack.

In an example, a moment when the voltage of the battery pack reaches the discharge cut-off voltage is defined as a discharge endpoint, and the endpoint DoD is defined as the DoD corresponding to the voltage at the discharge endpoint.

In an example, the step of determining the endpoint DoD of the battery pack in the current working condition based on the voltage, the current, and the current DoD of the battery pack includes: adaptively learning an impedance curve in the current working condition based on the voltage, the current, and the current DoD of the battery pack; determining a voltage variation curve of the battery pack in the current working condition according to the impedance curve and the current DoD; and determining the endpoint DoD according to the voltage variation curve and the discharge cut-off voltage.

In an example, the detection assembly further includes a temperature sensor for acquiring temperature information of the battery pack; where the step of adaptively learning the impedance curve in the current working condition based on the voltage, the current, and the current DoD of the battery pack includes: based on the voltage and the current of the battery pack, calculating impedance information of the battery pack corresponding to the current DoD; and updating the impedance curve based on the impedance information and the temperature information.

In an example, the step of updating the impedance curve based on the impedance information and the temperature information includes: performing linear regression on the impedance information to obtain corrected impedance; calculating normalized impedance based on the corrected impedance and the temperature information; and updating the impedance curve according to the difference between the normalized impedance and the impedance corresponding to the current DoD in the impedance curve.

In an example, the overall SoH is determined according to the interval SoH of the battery pack through mapping.

The benefits of the present application are described below. The RSoC is provided so that it is easy for the user to understand the working expectation of the battery pack in the current working condition and reasonably evaluate the power requirements of the electrical device that needs to be used such as a power tool.

Therefore, an object of the present application is to provide a method for determining a discharge capability parameter (State of Power, SOP) of a battery pack and a power tool system.

To achieve the preceding object, the present application adopts the technical solutions below.

The present application provides a method for determining a discharge capability parameter (State of Power, SOP) of a battery pack. The battery pack includes a housing, multiple cells accommodated in the housing, a power tool interface disposed on the housing, and a first circuit board accommodated in the housing and electrically connected to the power tool interface, where a first controller is disposed on the first circuit board. The method for determining a discharge capability parameter of a battery pack includes: acquiring the voltage and the current of the battery pack through a detection assembly; determining the discharge capability parameter according to the voltage and the current of the battery pack; limiting the discharge of the battery pack according to the discharge capability parameter and then reacquiring the voltage of the battery pack; and updating the discharge capability parameter according to the difference between the reacquired voltage and the cut-off voltage of the battery pack.

In an example, the discharge capability parameter includes at least one of a first discharge capability parameter and a second discharge capability parameter; the first discharge capability parameter is the discharge capability of the battery pack when the battery pack is controlled to be discharged instantaneously to the cut-off voltage; and the second discharge capability parameter is the discharge capability of the battery pack when the battery pack is controlled to be discharged continuously to the cut-off voltage.

In an example, when the target continuous discharge time is less than or equal to a first time threshold, the discharge capability parameter is defined as the first discharge capability parameter; and when the target continuous discharge time is greater than the first time threshold, the discharge capability parameter is defined as the second discharge capability parameter.

In an example, the discharge capability parameter is a current limit value or a power limit value.

In an example, the step of determining the discharge capability parameter according to the voltage and the current of the battery pack includes: determining a first reference value of the discharge capability parameter based on the voltage constraint; determining a second reference value of the discharge capability parameter based on the DoD constraint; determining a third reference value of the discharge capability parameter based on the first reference value and the second reference value; and determining the discharge capability parameter by limiting the third reference value based on temperature.

In an example, the first reference value is determined according to the open-circuit voltage and the resistance of the battery pack.

In an example, the second reference value is determined according to the remaining capacity of the battery pack.

In an example, the third reference value is the smaller value between the first reference value and the second reference value.

In an example, the step of updating the discharge capability parameter includes: determining a compensation value for the discharge capability parameter based on the difference between the reacquired voltage and the cut-off voltage of the battery pack, and the resistance of the battery pack.

In an example, the step of updating the discharge capability parameter further includes: timing the working condition in which discharging is performed when the discharge capability parameter is not reached, and determining the weight of the compensation value according to the timing condition.

The present application provides a battery pack. The battery pack includes a housing, multiple cells accommodated in the housing, a detection assembly for detecting a state parameter of the battery pack, and a first circuit board accommodated in the housing, where a first controller is disposed on the first circuit board. The first controller is communicatively connected to the detection assembly and configured to acquire the state parameter of the battery pack and determine a discharge capability parameter of the battery pack according to the state parameter. The discharge capability parameter includes at least one of a first discharge capability parameter and a second discharge capability parameter. The first discharge capability parameter includes the discharge capability of the battery pack when the battery pack is controlled to be discharged instantaneously until the state of the battery pack satisfies a cut-off condition. The second discharge capability parameter includes the discharge capability of the battery pack when the battery pack is controlled to be discharged continuously until the state of the battery pack satisfies the cut-off condition. The battery pack further includes a power tool interface electrically connected to the first controller and used for connecting a power tool to send the discharge capability parameter to the power tool.

In an example, the discharge capability parameter includes a current limit value or a power limit value.

In an example, the state parameter includes the current, voltage, and temperature of the battery pack; the first controller is specifically configured to calculate the SoC of the battery pack according to the current and the voltage, determine the instantaneous direct current (DC) resistance and/or continuous DC resistance of the battery pack according to the SoC and the temperature, determine the first discharge capability parameter according to the cut-off condition and the instantaneous DC resistance of the battery pack, and/or determine the second discharge capability parameter according to the cut-off condition and the continuous DC resistance.

In an example, the first controller is further configured to determine the instantaneous voltage before discharge and the continuous voltage before discharge of the battery pack according to the current, determine the first discharge capability parameter according to the instantaneous voltage before discharge, the cut-off condition, and the instantaneous DC resistance of the battery pack, and/or determine the second discharge capability parameter according to the continuous voltage before discharge, the cut-off condition, and the continuous DC resistance; where the first discharge capability parameter and the second discharge capability parameter each include the current limit value.

In an example, the state parameter includes the current, voltage, and temperature of the battery pack; the first controller is specifically configured to determine a first reference value of the discharge capability parameter based on the voltage constraint, determine a second reference value of the discharge capability parameter based on the DoD constraint, determine a third reference value based on the first reference value and the second reference value, and determine the discharge capability parameter by limiting the third reference value based on the temperature.

The present application further provides a power tool system. The power tool system includes: a battery pack including a housing, multiple cells accommodated in the housing, a power tool interface disposed on the housing, and a first circuit board accommodated in the housing and electrically connected to the power tool interface, where a first controller is disposed on the first circuit board; a power tool including a body housing, a battery pack interface disposed on the body housing and used for electrically and communicatively connecting the power tool interface, and a second circuit board accommodated in the body housing and electrically connected to the battery pack interface, where a second controller is disposed on the second circuit board; and a detection assembly for detecting at least the voltage and the current of the battery pack, where the detection assembly is disposed in the housing of the battery pack and/or the body housing of the power tool. The first controller or the second controller is communicatively connected to the detection assembly and is configured to acquire the voltage and the current of the battery pack and determine a discharge capability parameter of the battery pack according to the voltage and the current of the battery pack. The discharge capability parameter includes at least one of a first discharge capability parameter and a second discharge capability parameter. The first discharge capability parameter includes the discharge capability of the battery pack when the battery pack is controlled to be discharged instantaneously until the state of the battery pack satisfies a cut-off condition. The second discharge capability parameter includes the discharge capability of the battery pack when the battery pack is controlled to be discharged continuously until the state of the battery pack satisfies the cut-off condition. The second controller is further configured to control the discharge of the power tool according to the discharge capability parameter.

In an example, when the first controller is configured to determine the discharge capability parameter of the battery pack, the discharge capability parameter is further sent to the second controller through the power tool interface and the battery pack interface.

In an example, after the second controller controls the discharge of the power tool according to the discharge capability parameter, the first controller or the second controller is further configured to reacquire the voltage of the battery pack and update the discharge capability parameter according to the difference between the reacquired voltage and the cut-off voltage of the battery pack.

In an example, the step of updating the discharge capability parameter includes: determining a compensation value for the discharge capability parameter based on the difference between the reacquired voltage and the cut-off voltage of the battery pack and the resistance of the battery pack.

In an example, the step of updating the discharge capability parameter further includes: timing the working condition in which discharging is performed when the discharge capability parameter is not reached, and determining the weight of the compensation value according to the timing condition.

The benefits of the present application are described below. The discharge capability parameter of the battery pack can be determined according to the current working condition of the battery pack, and accuracy compensation is performed on the discharge capability parameter to make the discharge capability parameter more accurate, which is conducive to the following: the discharge of the power tool can be performed according to the limitation of the discharge capability parameter of the battery pack.

Therefore, an object of the present application is to provide a method for evaluating an SoH of a battery pack.

To achieve the preceding object, the present application adopts the technical solutions below.

The present application provides a method for evaluating an SoH of a battery pack. The battery pack includes a housing, multiple cells accommodated in the housing, a power tool interface disposed on the housing, and a first circuit board accommodated in the housing and electrically connected to the power tool interface, where a first controller is disposed on the first circuit board. The evaluation method includes: estimating the interval SoH of the battery pack within a preset voltage interval during a charging process of the battery pack and determining the overall SoH of the battery pack according to the interval SoH and a preset mapping model.

In an example, the method for evaluating an SoH of a battery pack further includes: acquiring the voltage of the battery pack after a preset time period since the start of charging; and if the voltage is less than the minimum value in the preset voltage interval, estimating the interval SoH when the charge voltage is within the preset voltage interval.

In an example, the method for evaluating an SoH of a battery pack further includes: acquiring the voltage of the battery pack after a preset time period since the start of charging; and if the charge voltage is greater than or equal to the minimum value in the preset voltage interval, not estimating the interval SoH during this charging process.

In an example, the method for evaluating an SoH of a battery pack further includes: acquiring the temperature of the battery pack after a preset time period since the start of charging; and if the temperature of the battery pack exceeds a preset temperature interval, not estimating the interval SoH during this charging process.

In an example, the method for evaluating an SoH of a battery pack further includes: acquiring the charge current of the battery pack within the preset voltage interval; searching for a health assessment reference value of the battery pack within the preset voltage interval according to the charge current; and if the health assessment reference value corresponding to the charge current cannot be found, not estimating the interval SoH during this charging process.

In an example, the method for evaluating an SoH of a battery pack further includes: if the health assessment reference value corresponding to the charge current is found, calculating the actual charge capacity of the battery pack within the preset voltage interval and estimating the interval SoH according to the actual charge capacity and the health assessment reference value.

The present application provides a method for evaluating an SoH of a battery pack. The battery pack includes a housing, multiple cells accommodated in the housing, a power tool interface disposed on the housing, and a first circuit board accommodated in the housing and electrically connected to the power tool interface, where a first controller is disposed on the first circuit board. The evaluation method includes a method for calculating a health assessment reference value. The calculation method includes: calculating the actual charge capacity of the battery pack within a preset voltage interval during a charging process of the battery pack and calculating the health assessment reference value of the battery pack within the preset voltage interval according to the actual charge capacity and the interval SoH stored in the battery pack.

In an example, the method for evaluating an SoH of a battery pack further includes: acquiring the charge current of the battery pack within the preset voltage interval; searching for a health assessment reference value of the battery pack within the preset voltage interval according to the charge current; and if the health assessment reference value corresponding to the charge current cannot be found, invoking a calculation method to calculate the health assessment reference value corresponding to the charge current.

The present application further provides a charger and a battery pack for performing the preceding SoH assessment method.

The benefits of the present application are described below. The overall SoH is evaluated through the interval SoH of the battery pack, and it is not required to evaluate the SoH of the battery pack during a complete charge and/or discharge cycle, so the evaluation condition can be satisfied more easily. In addition, when the battery pack is connected to a new charging device, self-learning can be performed, and the corresponding health assessment reference value can be stored; and when the charging device is used again next time, the health assessment reference value can be used to estimate the interval SoH of the battery pack.

Therefore, an object of the present application is to provide a battery pack, a method for estimating the charge/discharge completion time of the battery pack, and an electrical device system.

To achieve the preceding object, the present application adopts the technical solutions below.

The present application provides a method for estimating the charge/discharge completion time of a battery pack. The battery pack includes a housing, multiple cells accommodated in the housing, a power tool interface disposed on the housing, and a first circuit board accommodated in the housing and electrically connected to the power tool interface, where a first controller is disposed on the first circuit board. The estimation method includes: acquiring the voltage and the current of the battery pack through a detection assembly; determining the current DoD of the battery pack based on the voltage and the current of the battery pack; determining a voltage variation curve of the battery pack in the current working condition based on an impedance curve and the current DoD of the battery pack; determining the endpoint DoD of the battery pack at the charge/discharge endpoint based on the voltage variation curve and the charge/discharge cut-off voltage of the battery pack; and determining the charge/discharge completion time based on the current DoD and the endpoint DoD.

In an example, the step of determining the current DoD of the battery pack based on the voltage and the current of the battery pack includes: calculating the initial DoD based on the voltage of the battery pack at rest and calculating the current DoD based on the initial DoD, the maximum chemical capacity, and the current of the battery pack.

In an example, the step of determining the voltage variation curve of the battery pack in the current working condition based on the impedance curve and the current DoD of the battery pack includes: using the current DoD as the starting point, simulating and calculating the voltage of the battery pack in a variable step-size stepping manner, and generating the voltage variation curve.

In an example, the step of determining the endpoint DoD of the battery pack at the charge/discharge endpoint based on the voltage variation curve and the charge/discharge cut-off voltage of the battery pack during a discharging process of the battery pack includes: using the DoD corresponding to the discharge cut-off voltage in the voltage variation curve as the endpoint DoD.

In an example, the step of determining the endpoint DoD of the battery pack at the charge/discharge endpoint based on the voltage variation curve and the charge/discharge cut-off voltage of the battery pack during a charging process of the battery pack includes: using the DoD corresponding to the charge cut-off voltage in the voltage variation curve as the endpoint DoD.

In an example, the step of determining the charge/discharge completion time based on the current DoD and the endpoint DoD includes: calculating the charge/discharge completion time according to a first calculation formula. The first calculation formula is described below.

$$T = |DoD_{final} - DoD_{now}| * Q_{max}/I_{now}.$$

T denotes the charge/discharge completion time, $DoD_{final}$ denotes the endpoint DoD, $DoD_{now}$ denotes the current DoD, $Q_{max}$ denotes the maximum chemical capacity of the battery pack, and $I_{now}$ denotes the current of the battery pack at the current moment.

In an example, before the charge/discharge completion time is calculated according to the first calculation formula, the following is further included: updating the maximum chemical capacity according to the current and the current DoD.

In an example, the estimation method further includes: adaptively learning the impedance curve in the current working condition based on the voltage, the current, and the current DoD of the battery pack.

In an example, the detection assembly further includes a temperature sensor for acquiring temperature information of the battery pack; where the step of adaptively learning the impedance curve in the current working condition based on the voltage, the current, and the current DoD of the battery pack includes: based on the voltage and the current of the battery pack, calculating impedance information of the battery pack corresponding to the current DoD; and updating the impedance curve based on the impedance information and the temperature information.

In an example, the step of updating the impedance curve based on the impedance information and the temperature information includes: performing linear regression on the impedance information to obtain corrected impedance; calculating normalized impedance based on the corrected impedance and the temperature information; and updating the impedance curve according to the difference between the normalized impedance and the impedance corresponding to the current DoD in the impedance curve.

In an example, after the charge/discharge completion time is determined based on the current DoD and the endpoint DoD, the following is further included: smoothing the charge/discharge completion time.

The present application further provides an electrical device system. The electrical device system includes: a battery pack including a housing, multiple cells accommodated in the housing, a power tool interface disposed on the housing, and a first circuit board accommodated in the housing and electrically connected to the power tool interface, where a first controller is disposed on the first circuit board; a body including a body housing, a battery pack interface disposed on the body housing and used for electrically and communicatively connecting the power tool interface, and a second circuit board accommodated in the body housing and electrically connected to the battery pack interface, where a second controller is disposed on the second circuit board; and a detection assembly for detecting at least the voltage and the current of the battery pack, where the detection assembly is disposed in the housing of the battery pack and/or the body housing of the body. The first controller or the second controller is communicatively connected to the detection assembly and includes a DoD determination module configured to determine the current DoD of the battery pack based on the voltage and the current of the battery pack, a voltage variation curve determination module configured to determine a voltage variation curve of the battery pack in the current working condition based on an impedance curve and the current DoD of the battery pack, a charge/-discharge endpoint determination module configured to determine the endpoint DoD of the battery pack at the charge/discharge endpoint based on the voltage variation curve and the charge/discharge cut-off voltage of the battery pack, and a charge/discharge completion time determination module configured to determine the charge/discharge completion time of the battery pack based on the current DoD and the endpoint DoD.

In an example, the first controller or the second controller further includes an impedance curve update module configured to adaptively learn the impedance curve in the current working condition based on the voltage, the current, and the current DoD of the battery pack.

In an example, the first controller or the second controller further includes a maximum chemical capacity update module configured to update the maximum chemical capacity of the battery pack according to the current and the current DoD.

The present application further provides a battery pack. The battery pack includes a housing, multiple cells accommodated in the housing, a power tool interface disposed on the housing, a detection assembly for detecting at least the voltage of the battery pack, and a first circuit board accommodated in the housing and electrically connected to the power tool interface, where a first controller is disposed on the first circuit board. The first controller is communicatively connected to the detection assembly and configured to acquire the voltage and the current of the battery pack, determine the current DoD of the battery pack based on the voltage and the current of the battery pack, determine the voltage variation curve of the battery pack in the current working condition based on an impedance curve and the DoD of the battery pack, determine the endpoint DoD of the battery pack at the charge/discharge endpoint based on the voltage variation curve and the charge/discharge cut-off voltage of the battery pack, and determine the charge/discharge completion time of the battery pack based on the current DoD and the endpoint DoD.

The benefits of the present application are described below. The DoD of the battery pack is calculated in real time based on the data acquired by a voltage sensor and a current sensor of the battery pack, thereby determining the voltage variation curve of the battery pack based on the impedance curve of the battery pack and the DoD of the battery pack. Then, the DoD of the battery pack at the charge/discharge endpoint is determined according to the voltage variation curve and the charge/discharge cut-off voltage of the battery pack. Finally, the charge/discharge completion time of the battery pack is calculated according to the DoD of the battery pack at the charge/discharge endpoint and the DoD of the battery pack at the current moment. In this manner, the charge/discharge completion time of the battery pack can be calculated according to the real-time state of the battery pack so that the charge/discharge completion time of the battery pack is not affected by the battery capacity, load size, charger characteristics, and usage environment, which is conducive to improving the calculation accuracy of the estimated completion time of the battery pack being charged and discharged, thereby improving the user experience.

## BRIEF DESCRIPTION OF DRAWINGS

FIG. 1 is a flowchart of a method for estimating the charge/discharge completion time of a battery pack according to an example of the present application.

FIG. 2 is a graph of a voltage variation curve of a battery pack according to an example of the present application.

FIG. 3 is a flowchart of another method for estimating the charge/discharge completion time of a battery pack according to an example of the present application.

FIG. 4 is a block diagram of a device for estimating the charge/discharge completion time of a battery pack according to an example of the present application.

FIG. 5 is a flowchart of another method for estimating the charge/discharge completion time of a battery pack according to an example of the present application.

FIG. 6 is a graph of an impedance curve according to an example of the present application.

FIG. 7 is a block diagram of another device for calculating the charge/discharge completion time of a battery pack according to an example of the present application.

FIG. 8A is a block diagram of a power tool system according to an example of the present application.

FIG. 8B is a block diagram of another power tool system according to an example of the present application.

FIG. 8C is a block diagram of another power tool system according to an example of the present application.

FIG. 9 is a graph of a relationship curve between the cut-off voltage and the temperature of a battery pack according to an example of the present application.

FIG. 10 is a graph of a relationship curve between the limiting current and the temperature of a battery pack according to an example of the present application.

FIG. 11 is a flowchart of a method for determining a discharge capability parameter of a battery pack according to an example of the present application.

FIG. 12 is a flowchart of another method for determining a discharge capability parameter of a battery pack according to an example of the present application.

FIG. 13 is a flowchart of another method for determining a discharge capability parameter of a battery pack according to an example of the present application.

FIG. 14 is a view illustrating the structure of an electrical device system according to an example of the present application.

FIG. 15 is a schematic view of some structures of a power tool in FIG. 14.

FIG. 16 is a view illustrating the structure of a battery pack in FIG. 14.

FIG. 17 is an exploded view of a battery pack in FIG. 14.

FIG. 18 is a view illustrating the structure of another electrical device system according to an example of the present application.

FIG. 19 is a view illustrating the structure of a charger in FIG. 18.

FIG. 20 is a flowchart of a method for estimating an SoH of a battery pack according to an example of the present application.

FIG. 21 is a statistical graph illustrating predicted and actual battery pack charging completion time according to an example of the present application.

FIG. 22 is a statistical graph illustrating predicted and actual battery pack discharging completion time according to an example of the present application.

## DETAILED DESCRIPTION

Before any examples of this application are explained in detail, it is to be understood that this application is not limited to its application to the structural details and the arrangement of components set forth in the following description or illustrated in the above drawings.

In this application, the terms "comprising", "including", "having" or any other variation thereof are intended to cover an inclusive inclusion such that a process, method, article or device comprising a series of elements includes not only those series of elements, but also other elements not expressly listed, or elements inherent in the process, method, article, or device. Without further limitations, an element defined by the phrase "comprising a ..." does not preclude the presence of additional identical elements in the process, method, article, or device comprising that element.

In this application, the term "and/or" is a kind of association relationship describing the relationship between associated objects, which means that there can be three kinds of relationships. For example, A and/or B can indicate that A exists alone, A and B exist simultaneously, and B exists alone. In addition, the character "/" in this application generally indicates that the contextual associated objects belong to an "and/or" relationship.

In this application, the terms "connection", "combination", "coupling" and "installation" may be direct connection, combination, coupling or installation, and may also be indirect connection, combination, coupling or installation. Among them, for example, direct connection means that two members or assemblies are connected together without intermediaries, and indirect connection means that two members or assemblies are respectively connected with at least one intermediate members and the two members or assemblies are connected by the at least one intermediate members. In addition, "connection" and "coupling" are not limited to physical or mechanical connections or couplings, and may include electrical connections or couplings.

In this application, it is to be understood by those skilled in the art that a relative term (such as "about", "approximately", and "substantially") used in conjunction with quantity or condition includes a stated value and has a meaning dictated by the context. For example, the relative term includes at least a degree of error associated with the measurement of a particular value, a tolerance caused by manufacturing, assembly, and use associated with the particular value, and the like. Such relative term should also be considered as disclosing the range defined by the absolute values of the two endpoints. The relative term may refer to plus or minus of a certain percentage (such as 1%, 5%, 10%, or more) of an indicated value. A value that did not use the relative term should also be disclosed as a particular value with a tolerance. In addition, "substantially" when expressing a relative angular position relationship (for example, substantially parallel, substantially perpendicular), may refer to adding or subtracting a certain degree (such as 1 degree, 5 degrees, 10 degrees or more) to the indicated angle.

In this application, those skilled in the art will understand that a function performed by an assembly may be performed by one assembly, multiple assemblies, one member, or multiple members. Likewise, a function performed by a member may be performed by one member, an assembly, or a combination of members.

In this application, the terms "up", "down", "left", "right", "front", and "rear" and other directional words are described based on the orientation or positional relationship shown in the drawings, and should not be understood as limitations to the examples of this application. In addition, in this context, it also needs to be understood that when it is mentioned that an element is connected "above" or "under" another element, it can not only be directly connected "above" or "under" the other element, but can also be indirectly connected "above" or "under" the other element through an intermediate element. It should also be understood that orientation words such as upper side, lower side, left side, right side, front side, and rear side do not only represent perfect orientations, but can also be understood as lateral orientations. For example, lower side may include directly below, bottom left, bottom right, front bottom, and rear bottom.

It should be noted that the terms "first", "second", etc. in the detailed description and claims of the present application and the above-mentioned drawings are used to distinguish similar objects, and are not necessarily used to describe a specific order or sequence. It should be understood that the data used in this way can be interchangeable where appropriate, so that the embodiments of the present application described herein can be implemented in an order other than those illustrated or described herein. In addition, the term "comprising" and any variation thereof are intended to cover non-exclusive inclusions, for example, a process, method, system, product or device comprising a series of steps or units is not necessarily limited to those steps or units clearly listed, but may include other steps or units that are not clearly listed or inherent to these processes, methods, products or devices.

In this application, the terms "controller", "processor", "central processor", "CPU" and "MCU" are interchangeable. Where a unit "controller", "processor", "central processing", "CPU", or "MCU" is used to perform a specific function, the specific function may be implemented by a single aforementioned unit or a plurality of the aforementioned unit.

In this application, the term "device", "module" or "unit" may be implemented in the form of hardware or software to achieve specific functions.

In this application, the terms "computing", "judging", "controlling", "determining", "recognizing" and the like refer to the operations and processes of a computer system or similar electronic computing device (e.g., controller, processor, etc.).

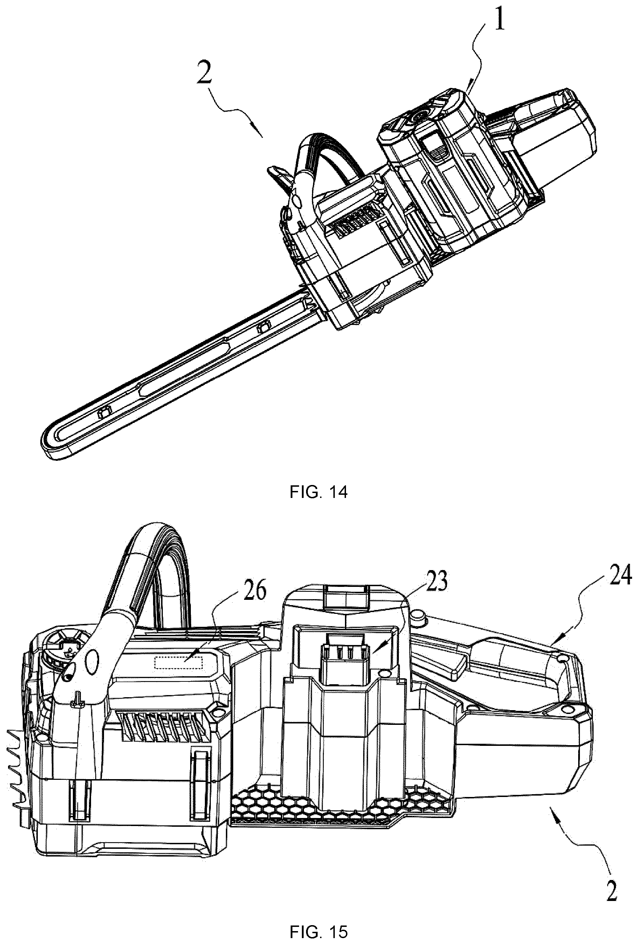

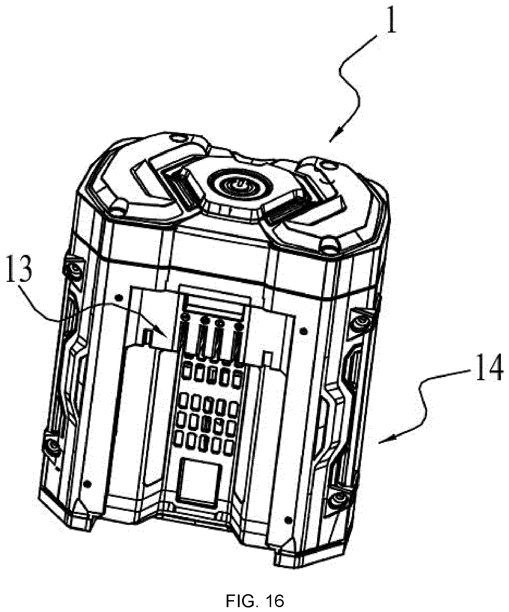

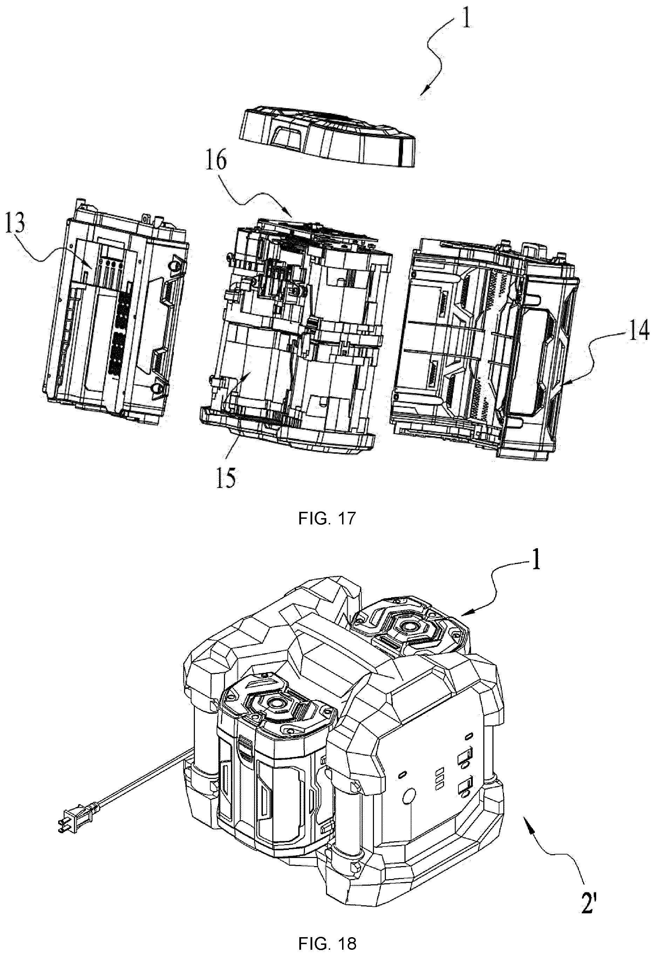

FIGS. 14 to 19 are each a view illustrating the structure of an electrical device system provided in the present application. The electrical device system includes a battery pack 1 and a body 2. The battery pack 1 is coupled to the body 2 and can transmit electrical energy to the body 2. In an example, the electrical device system may be a power tool system, and the body 2 is a power tool 2, such as a chainsaw. The power tool 2 is powered by the battery pack 1. The battery pack 1 includes a housing 14, multiple cells 15 accommodated in the housing 14, a power tool interface 13 disposed on the housing 14, and a first circuit board 16 accommodated in the housing 14. A first controller 12 is disposed on the first circuit board 16 and used for the power management of the battery pack 1. The battery pack 1 is coupled to a battery pack interface 23 of the power tool 2 through the power tool interface 13, thereby achieving electrical connection and communication connection. The power tool 2 further includes a body housing 24, and the battery pack interface 23 is disposed on the body housing 24. The body housing 24 accommodates a second circuit board 26, and a second controller 21 is disposed on the second circuit board 26 and used for controlling the power tool 2. In another example, the electrical device system may be a charging system, and the body 2 is a charger 2'. The charger 2' includes a body housing 24', and a battery pack interface 23' is disposed on the body housing 24'. The body housing 24' accommodates a second circuit board 26', and a second controller 21' is disposed on the second circuit board 26' and used for controlling the charger 2'. The electrical device system or components (such as the battery pack 1 and the body 2) in the system can execute the algorithm provided in the present application to estimate and evaluate the State of Health (SoH), the State of Capacity (SoC), the discharge capability parameter (State of Power, SOP), and the charge/discharge completion time of the battery pack 1. The charger 2' shown in the figure has two battery pack interfaces 23' used for charging two battery packs at the same time and evaluating the relevant parameters of the two battery packs. A body with another number of battery pack interfaces may also use the algorithm provided in the present application.

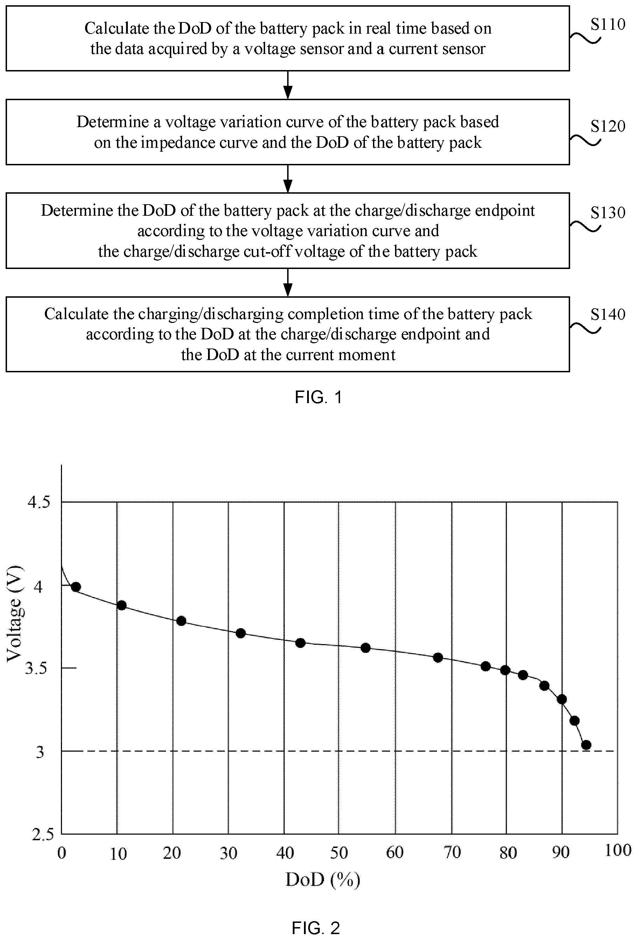

FIG. 1 is a flowchart of a method for estimating the charge/discharge completion time of a battery pack according to an example of the present application. This example provides a method for estimating the charge/discharge completion time of a battery pack. The method may be performed by a device for calculating the charge/discharge completion time of a battery pack. The device may be implemented by hardware and/or software. As shown in FIG. 1, the method includes the steps below.

In S110, the DoD of the battery pack is calculated in real time based on the data acquired by a voltage sensor and a current sensor.

The battery pack includes a detection assembly, and the detection assembly includes the voltage sensor and the current sensor. The voltage sensor is used for acquiring the voltage data of the battery pack in real time. The voltage data may include, but is not limited to, the voltage information of the battery pack at rest and the voltage information of the battery pack during the charge/discharge process. The voltage information of the battery pack at rest is the open-circuit voltage of the battery pack. The open-circuit voltages of the battery pack at different discharge depths (the plural form of DoD) may be measured in advance and stored in the battery pack. The current sensor is used for acquiring the current data of the battery pack in real time.

The charge/discharge completion time of the battery pack may be understood as the time required for the state of the battery pack to reach the charging cut-off condition when the battery pack is charged or the time required for the state of the battery pack to reach the discharging cut-off condition when the battery pack is discharged. In an optional example, the charging cut-off condition is the charge cut-off voltage. In an optional example, the discharging cut-off condition is the discharge cut-off voltage. In an optional example, the charging cut-off condition is the charging cut-off SoC. In an optional example, the discharging cut-off condition is the discharging cut-off SoC.

The DoD of the battery pack refers to the percentage of the discharge capacity of the battery pack to the rated capacity of the battery pack. When the battery pack is at rest, its DOD is a fixed value. In an optional example, the DoD of the battery pack at rest is obtained according to the voltage acquired by the voltage sensor, that is, the open-circuit voltage of the battery pack, and a relationship table between the open-circuit voltage and the DoD. The voltage of the battery pack changes dynamically during charge/discharge. In an optional example, when the battery pack is charged, the DoD of the battery pack in the current state is obtained according to the DoD of the battery pack at the previous moment and the charge increased in the battery pack in the period from the previous moment to the current moment. The charge increased in the battery pack in the period from the previous moment to the current moment can be obtained from the current information in the period. In an optional example, when the battery pack is discharged, the DoD of the battery pack in the current state is obtained according to the DoD of the battery pack at the previous moment and the charge decreased in the battery pack in the period from the previous moment to the current moment. The charge decreased in the battery pack in the period from the previous moment to the current moment can also be obtained from the current information in the period.

In S120, a voltage variation curve of the battery pack is determined based on an impedance curve and the DoD of the battery pack.

The impedance curve of the battery pack is a curve of the internal resistance of the battery pack corresponding to different discharge depths, and the impedance curve of the battery pack may be determined by pre-measurement and stored in the battery pack. In an example, the impedance value of the impedance curve is the value of normalized impedance that is decoupled from the influence of temperature; and an impedance curve incorporating the influence of temperature may be created from said impedance curve in conjunction with a temperature prediction curve of the battery pack. Further, in conjunction with the current in the current working condition and the open-circuit voltages of the battery pack at different discharge depths, the voltages of the battery pack corresponding to different discharge depths can be predicted, thereby generating the voltage variation curve for the current working condition.

FIG. 2 is a schematic diagram of a voltage variation curve of a battery pack according to an example of the present application. In an optional example, based on the impedance curve of the battery pack, the DoD of the battery pack calculated in real time, and the open-circuit voltages of the battery pack at different discharge depths, the voltages of the battery pack corresponding to different discharge depths of the battery pack starting from the current moment can be simulated and calculated, thereby generating the voltage variation curve of the battery pack as shown in FIG. 2.

In S130, the DoD of the battery pack at the charge/discharge endpoint is determined according to the voltage variation curve and the charge/discharge cut-off voltage of the battery pack.

The DoD of the battery pack at the charge/discharge endpoint refers to the corresponding DoD when the battery pack reaches the charging cut-off condition during charging or the corresponding DoD when the battery pack reaches the discharging cut-off condition during discharging. In an optional example, the charging cut-off condition is the charge cut-off voltage. In another optional example, the discharging cut-off condition is the discharge cut-off voltage.

Specifically, after the voltage variation curve is generated, set the DoD corresponding to the charge/discharge cut-off voltage of the battery pack in the voltage variation curve as the DoD at the charge/discharge endpoint of the battery pack.

In S140, the charge/discharge completion time of the battery pack is calculated according to the DoD at the charge/discharge endpoint and the DoD at the current moment.

The charge/discharge completion time of the battery pack refers to the time required for the DoD of the battery pack to reach the DoD at the charge/discharge endpoint from the DoD at the current moment. Specifically, when the battery pack is charged, the charging completion time of the battery pack refers to the time required for the DoD of the battery pack to reach the DoD at the charge endpoint. When the battery pack is discharged, the discharging completion time of the battery pack refers to the time required for the DoD of the battery pack to reach the DoD at the discharge endpoint.

Specifically, the DoD of the battery pack is calculated in real time based on the data acquired by the voltage sensor and the current sensor, that is, the voltage data and the current data. Then, the voltage variation curve of the battery pack is determined based on the impedance curve of the battery pack and the DoD of the battery pack. Then, the DoD of the battery pack at the charge/discharge endpoint is determined according to the voltage variation curve and the charge/discharge cut-off voltage of the battery pack stored in the battery pack. Finally, the charge/discharge completion time of the battery pack can be calculated based on the DoD of the battery pack at the charge/discharge endpoint and the DoD of the battery pack at the current moment so that the charge/discharge completion time of the battery pack can be updated in real time, which is conducive to improving the accuracy of estimating the charge/discharge completion time of the battery pack.

In this example, the DoD of the battery pack is calculated in real time based on the data acquired by the voltage sensor and the current sensor of the battery pack, thereby determining the voltage variation curve of the battery pack based on the impedance curve of the battery pack and the DoD of the battery pack. Then, the DoD of the battery pack at the charge/discharge endpoint is determined according to the voltage variation curve and the charge/discharge cut-off voltage of the battery pack. Finally, the charge/discharge completion time of the battery pack is calculated according to the DoD of the battery pack at the charge/discharge endpoint and the DoD of the battery pack at the current moment. In this manner, the charge/discharge completion time of the battery pack can be calculated according to the real-time state of the battery pack so that the charge/discharge completion time of the battery pack is not affected by the battery capacity, load size, charger characteristics, and usage environment, which is conducive to improving the calculation accuracy of the estimated completion time of the battery pack being charged and discharged, thereby improving the user experience.

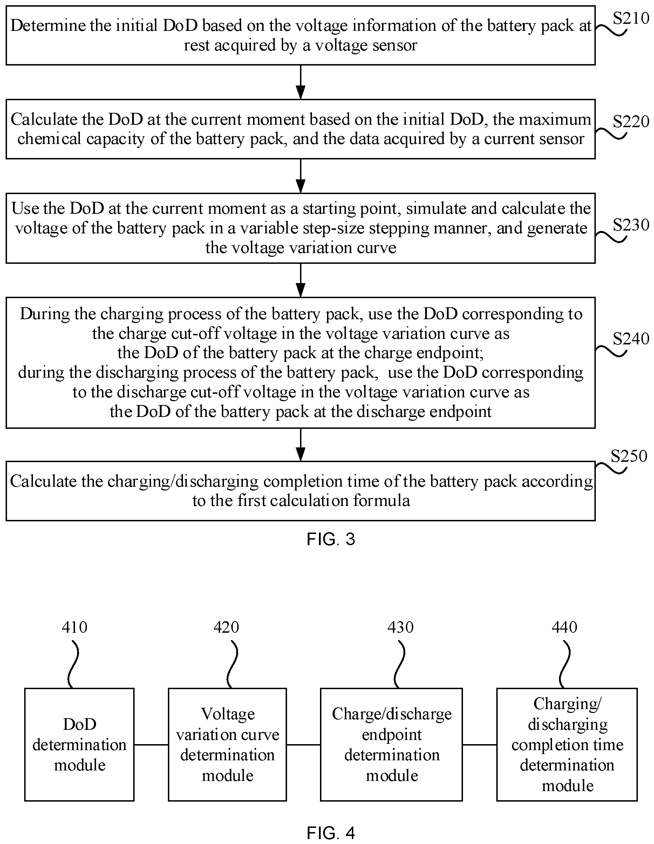

Optionally, FIG. 3 is a flowchart of another method for estimating the charge/discharge completion time of a battery pack according to an example of the present application. Based on the preceding examples, in this example, the following steps: how to calculate the DoD of the battery pack, how to determine the voltage variation curve of the battery pack, how to determine the DoD of the battery pack at the charge/discharge endpoint, and how to calculate the charge/discharge completion time of the battery pack are further provided. Referring to FIG. 3, the method specifically includes the steps below.

In S210, the initial DoD is determined based on the voltage information of the battery pack at rest acquired by a voltage sensor.

Herein, the battery pack at rest may be understood as the battery pack not being charged or discharged. The voltage information of the battery pack at rest acquired by the voltage sensor is the open-circuit voltage of the battery pack at the current moment.

In an optional example, the voltage sensor acquires the open-circuit voltages of the battery pack at different discharge depths, and the correspondence data is stored in the battery pack. Before the battery pack starts to be charged or discharged, the voltage sensor acquires the voltage information of the battery pack. The DoD of the battery pack at the current moment, that is, the initial DoD of the battery pack, can be determined based on the correspondence data of open-circuit voltages and discharge depths stored in the battery pack.

In S220, the DoD at the current moment is calculated based on the initial DoD, the maximum chemical capacity of the battery pack, and the data acquired by a current sensor.

The maximum chemical capacity of the battery pack may be understood as the chemical capacity of the fully charged battery pack. The data acquired by the current sensor may be the current data. In an optional example, the change in charge in the battery pack per unit time may be calculated based on the current data acquired by the current sensor. For example, during the charging process of the battery pack, the quantity of electric charge increased in the battery pack per unit time is calculated based on the current data acquired by the current sensor. During the discharging process of the battery pack, the quantity of electric charge decreased in the battery pack per unit time is calculated based on the current data acquired by the current sensor. In an optional example, the change in charge in the battery pack per unit time may be calculated in an ampere-hour integral method. In this manner, the change in DoD can be calculated through the ratio of the quantity of electric charge increased/decreased in the battery pack to the maximum chemical capacity of the battery pack; in conjunction with the initial DoD of the battery pack, the DoD of the battery pack in real time can be obtained, thereby improving the accuracy of the obtained DoD of the battery pack, which is conducive to improving the accuracy of calculating the charge/discharge completion time of the battery pack.

In an optional example, before the initial DoD is determined based on the voltage information of the battery pack at rest acquired by the voltage sensor, the following is further included: determining the direction of the current in the battery pack according to the current data acquired in real time by the current sensor. When the direction of the current in the battery pack is positive, it is determined that the battery pack is being charged. On the contrary, when the direction of the current in the battery pack is negative, it is determined that the battery pack is being discharged.

In S230, the DoD at the current moment is used as a starting point, the voltage of the battery pack is simulated and calculated in a variable step-size stepping manner, and the voltage variation curve is generated.

Specifically, the DoD at the current moment is used as the starting point, simulation is performed in a variable step-size stepping manner to gradually superimpose different discharge depths, and the voltages of the battery pack at different discharge depths under future loads are simulated and calculated, thereby generating the voltage variation curve.

In an optional example, to simplify the simulation calculation process, it may be considered that the future load of the battery pack remains unchanged, that is, the battery pack maintains the current load while being charged or discharged. In some examples, the load of the battery pack may be understood as the current of the battery pack. In some examples, the load of the battery pack may be understood as the power of the battery pack.

In S240, during the charging process of the battery pack, the DoD corresponding to the charge cut-off voltage in the voltage variation curve is used as the DoD of the battery pack at the charge endpoint; during the discharging process of the battery pack, the DoD corresponding to the discharge cut-off voltage in the voltage variation curve is used as the DoD of the battery pack at the discharge endpoint.

The charge cut-off voltage may be understood as the set maximum voltage of the battery pack. When the voltage of the battery pack reaches the charge cut-off voltage, the battery pack is controlled to stop being charged, thereby protecting the battery pack. In an optional example, the charge cut-off voltage is the charging cut-off condition of the battery pack set at the factory. In this case, the charge cut-off voltage may be the voltage of the fully charged battery pack. In some examples, the charge cut-off voltage may be the charging cut-off condition set by the user. In this case, the charge cut-off voltage is set by the user through a button or a client according to needs. For example, when the user requires the battery pack to have as large a capacity as possible, the charge cut-off voltage may be set to the voltage of the fully charged battery pack. On the contrary, when the requirement of the user is to extend the service life of the battery pack, the charge cut-off voltage may be configured to be lower than the voltage corresponding to the fully charged battery pack.

The discharge cut-off voltage may be understood as the set minimum voltage of the battery pack. When the voltage of the battery pack reaches the discharge cut-off voltage, the battery pack is controlled to stop discharging, thereby protecting the battery pack. It is to be understood that, similar to the charge cut-off voltage, the discharge cut-off voltage may be the discharging cut-off condition of the battery pack set at the factory and may also be the discharging cut-off condition developed by the user according to needs. The similarities are not repeated here.

Specifically, after the voltage variation curve is generated from simulation calculation with the DoD at the current moment as the starting point, if the battery pack is in the charging process, the DoD corresponding to the charge cut-off voltage in the voltage variation curve is used as the DoD of the battery pack at the charge endpoint. If the battery pack is in the discharging process, the DoD corresponding to the discharge cut-off voltage in the voltage variation curve is used as the DoD of the battery pack at the discharge endpoint. Since the voltage variation curve is generated from real-time simulation calculation, the DoD corresponding to the charge/discharge cut-off voltage in the voltage variation curve changes in real time with the state of the battery pack at the current moment so that the determined DoD of the battery pack at the charge/discharge endpoint is more accurate, which is conducive to improving the accuracy of calculating the charge/discharge completion time of the battery pack.

In S250, the charge/discharge completion time of the battery pack is calculated according to the first calculation formula.

The first calculation formula is as follows: $T = |DoD_{final} - DoD_{now}| * Q_{max}/I_{now}$. T denotes the charge/-discharge completion time. $DoD_{final}$ denotes the DoD at the charge/discharge endpoint. $DoD_{now}$ denotes the DoD at the current moment. $Q_{max}$ denotes the maximum chemical capacity of the battery pack. $I_{now}$ denotes the current of the battery pack at the current moment.

Specifically, the charge/discharge state of the battery pack is determined based on the current data acquired by the current sensor of the battery pack. When it is determined that the battery pack is charged, the DoD at the current moment is calculated based on the initial DoD, the maximum chemical capacity of the battery pack, and the data acquired by the current sensor. Then, the DoD at the current moment is used as a starting point, the voltage of the battery pack is simulated and calculated in a variable step-size stepping manner, and thereby generating the voltage variation curve. Then, the DoD corresponding to the charge cut-off voltage in the voltage variation curve is used as the DoD of the battery pack at the charge endpoint. Finally, the charging completion time of the battery pack is calculated according to the first calculation formula. Correspondingly, when it is determined that the battery pack is discharged, the DoD at the current moment is calculated based on the initial DoD, the maximum chemical capacity of the battery pack, and the data acquired by the current sensor. The DoD at the current moment is used as a starting point, the voltage of the battery pack is simulated and calculated in a variable step-size stepping manner, and thereby generating the voltage variation curve. Then, the DoD corresponding to the discharge cut-off voltage in the voltage variation curve is used as the DoD of the battery pack at the discharge endpoint. Finally, the discharging completion time of the battery pack is calculated according to the first calculation formula. In this manner, the charge/discharge completion time of the battery pack can be estimated by calculating the state of the battery pack in real time so that the charge/discharge completion time of the battery pack can be more accurate, which is conducive to the following: the user can properly manage the usage time of the power tool according to the charge/discharge completion time of the battery pack.

In this example, the DoD at the current moment is used as the starting point, and the voltage of the battery pack is simulated and calculated in a variable step-size stepping manner to form the voltage variation curve so that the voltage variation curve is updated in real time according to the state of the battery pack, thereby making the DoD at the charge/discharge endpoint determined according to the voltage variation curve more accurate and improving the accuracy of the charge/discharge completion time of the battery pack. In addition, the charge/discharge completion time of the battery pack is calculated through the first calculation formula, which is conducive to simplifying the calculation process of the charge/discharge completion time of the battery pack, thereby saving computational resources.

Based on the same concept, the present application further provides a device for calculating the charge/discharge completion time of a battery pack. The device for calculating the charge/discharge completion time of a battery pack may be implemented by hardware and/or software. The battery pack includes a detection assembly, and the detection assembly includes the voltage sensor and the current sensor. FIG. 4 is a block diagram of a device for calculating the charge/discharge completion time of a battery pack according to an example of the present application. Referring to FIG. 4, the device for calculating the charge/discharge completion time of a battery pack includes a DoD determination module 410, a voltage variation curve determination module 420, a charge/discharge endpoint determination module 430, and a charge/discharge completion time determination module 440.

The DoD determination module 410 is used for calculating the DoD of the battery pack in real time based on the data acquired by a voltage sensor and a current sensor.

The voltage variation curve determination module 420 is used for determining a voltage variation curve of the battery pack based on an impedance curve and the DoD of the battery pack.

The charge/discharge endpoint determination module 430 is used for determining the DoD of the battery pack at the charge/discharge endpoint according to the voltage variation curve and the charge/discharge cut-off voltage of the battery pack.

The charge/discharge completion time determination module 440 is used for determining the charge/-discharge completion time of the battery pack based on the DoD at the charge/discharge endpoint and the DoD at the current moment.

The device for calculating the charge/discharge completion time of a battery pack provided in the example of the present application can perform the method for calculating the charge/discharge completion time of a battery pack provided in any example of the present application and has functional modules and beneficial effects corresponding to the performed method. For the similarities, reference may be made to the preceding description.

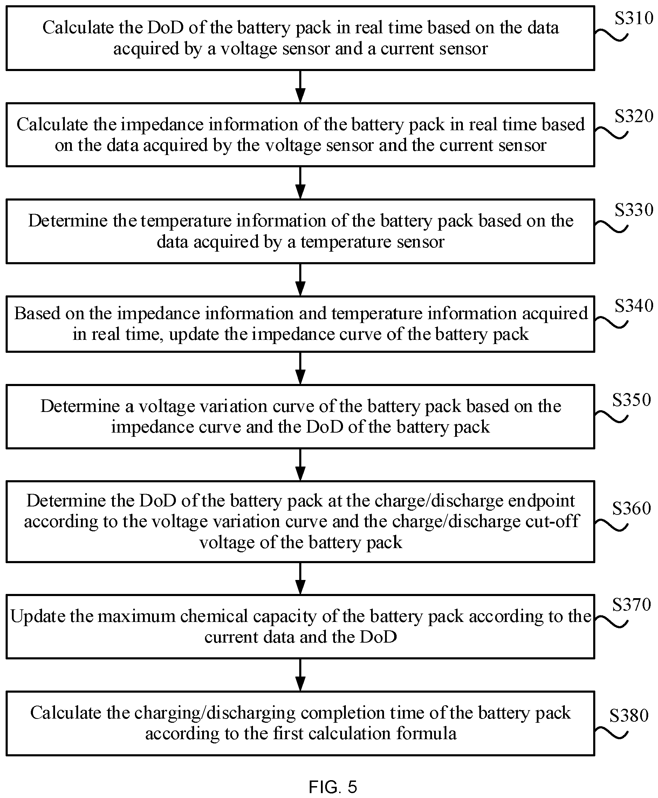

FIG. 5 is a flowchart of another method for calculating the charge/discharge completion time of a battery pack according to an example of the present application. Based on the preceding examples, in this example, the following steps of updating the impedance curve of the battery pack and updating the maximum chemical capacity of the battery pack are further provided. Referring to FIG. 5, the method specifically includes the steps below.

In S310, the DoD of the battery pack is calculated in real time based on the data acquired by a voltage sensor and a current sensor.

In S320, the impedance information of the battery pack is calculated in real time based on the data acquired by the voltage sensor and the current sensor.

The impedance information of the battery pack may be understood as the impedance of the battery pack at the current moment. Specifically, the impedance of the battery pack is calculated based on the voltage data acquired by the voltage sensor and the current data acquired by the current sensor.

In an optional example, the step of calculating the impedance information of the battery pack in real time based on the data acquired by the voltage sensor and the current sensor includes: after a preset time period since the start of charging/discharging, calculating the impedance information at the current moment in real time based on the terminal voltage and the open-circuit voltage of the battery pack acquired by the voltage sensor and the current of the battery pack acquired by the current sensor.

The preset time period may be determined according to the characteristics of the battery. In an optional example, the preset time period may be a period from the start of charging/discharging to the stabilization of the terminal voltage of the battery pack. In an exemplary example, the preset time period is 200 seconds.

In this example, after a preset time period since the start of charging/discharging, the impedance information at the current moment is calculated in real time based on the terminal voltage and the open-circuit voltage of the battery pack and the current of the battery pack so that the obtained impedance information is more accurate.

In S330, the temperature information of the battery pack is determined based on the data acquired by a temperature sensor.

The detection assembly further includes a temperature sensor. The temperature sensor is used for acquiring the temperature information of the battery pack in real time. The temperature information may include the current temperature and the temperature prediction curve. In an example, based on the data acquired by the temperature sensor, the heat generation and temperature change rate of the battery pack are calculated, thereby determining the temperature prediction curve of the battery pack.

In S340, the impedance curve of the battery pack is updated based on the impedance information and temperature information acquired in real time.

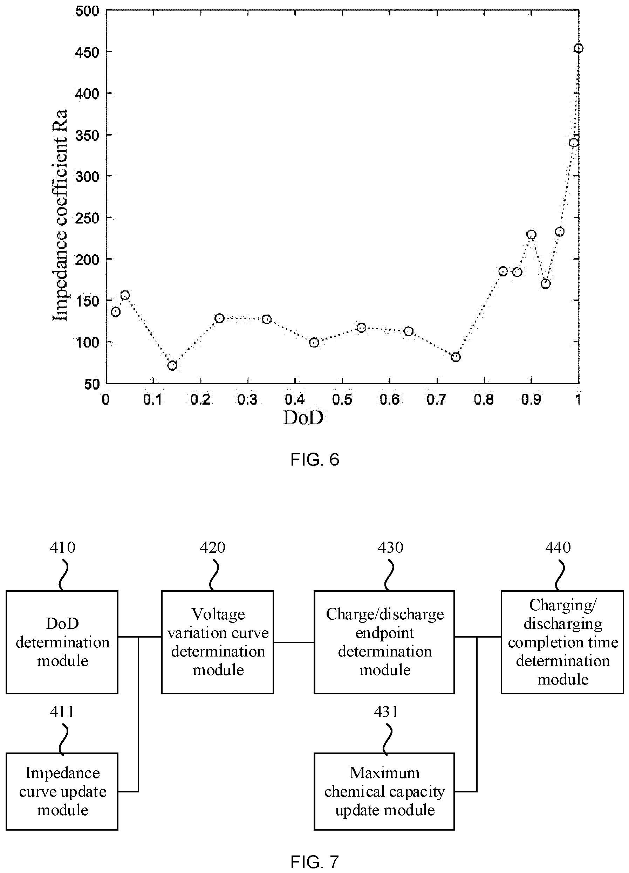

FIG. 6 is a schematic diagram of an impedance curve according to an example of the present application. Specifically, after the impedance information and the temperature information of the battery pack are obtained, the normalized impedance is calculated based on the impedance information and temperature information acquired in real time, and then the impedance curve of the battery pack is updated according to the normalized impedance. In an exemplary example, the updated impedance curve is shown in FIG. 6. In an optional example, the step of calculating the normalized impedance based on the impedance information and temperature information acquired in real time may include converting the impedance information acquired in real time into the impedance corresponding to 0°C according to the temperature information. The object of calculating the normalized impedance is to decouple the effect of temperature on the impedance. Through the difference between the normalized impedance calculated this time and the impedance of the battery pack corresponding to the current DoD in the impedance curve, the adjust ratio of the impedance of the battery pack in the current working condition can be obtained, and the impedance curve of the battery pack can be updated according to the adjust ratio. Due to conditions such as the existence of abnormal detection points, it is to be understood that a preset condition needs to be satisfied before the impedance curve of the battery pack is updated. In an optional example, if the normalized impedance does not satisfy the preset condition, the impedance corresponding to the DoD in the impedance curve of the battery pack is used as the impedance at the DoD in the updated impedance curve. The preset condition may be that the difference between the normalized impedance and the impedance corresponding to the DoD in the impedance curve of the battery pack is within a first preset range. The first preset range may be set according to actual situations.

In an optional example, the step of updating the impedance curve of the battery pack based on the impedance information and temperature information acquired in real time includes: performing linear regression on the impedance information acquired in real time to obtain the corrected impedance, and then the impedance curve of the battery pack is updated based on the corrected impedance and the temperature information.

In an optional example, to reduce the amount of calculation, performing linear regression on the impedance information acquired in real time may be understood as performing linear regression on a certain number of groups of impedance information most recently acquired in real time. For example, linear regression is performed on the most recently acquired four groups of impedance information to obtain the corrected impedance.

Specifically, after the impedance information and the temperature information of the battery pack are obtained, linear regression is performed on the impedance information acquired in real time to obtain the corrected impedance, and then the normalized impedance is calculated based on the corrected impedance and the temperature information, thereby updating the impedance curve of the battery pack according to the difference between the normalized impedance and the impedance corresponding to the current DoD in the impedance curve.

In S350, a voltage variation curve of the battery pack is determined based on the impedance curve and the DoD of the battery pack.

In S360, the DoD of the battery pack at the charge/discharge endpoint is determined according to the voltage variation curve and the charge/discharge cutoff voltage of the battery pack.

In S370, the maximum chemical capacity $Q_{max}$ of the battery pack is updated according to the current data and the DoD.

Specifically, the change in charge per unit time may be determined based on the current data acquired by the current sensor so that the maximum chemical capacity of the battery pack can be calculated and updated based on the change in charge per unit time and the DoD of the battery pack acquired in real time. In some examples, when the calculated maximum chemical capacity of the battery pack satisfies a swift update condition, the calculated maximum chemical capacity of the battery pack is stored as the maximum chemical capacity of the battery pack. In some examples, when the calculated maximum chemical capacity of the battery pack does not satisfy the swift update condition, the maximum chemical capacity of the battery pack is not updated. The swift update condition includes that the difference between the calculated maximum chemical capacity of the battery pack and the maximum chemical capacity stored in the battery pack is within a second preset range. The second preset range may be set according to actual situations.

In S380, the charge/discharge completion time of the battery pack is calculated according to the first calculation formula.

The first calculation formula is as follows: $T = |DoD_{final} - DoD_{now}| * Q_{max}/I_{now}$. T denotes the charge/discharge completion time. $DoD_{final}$ denotes the DoD at the charge/discharge endpoint, that is, the endpoint DoD. $DoD_{now}$ denotes the DoD at the current moment, that is, the current DoD. $Q_{max}$ denotes the maximum chemical capacity of the battery pack. $I_{now}$ denotes the current of the battery pack at the current moment.

In an optional example, after the charge/discharge completion time of the battery pack is calculated, the following is further included: smoothing the charge/discharge completion time.

The smoothing of the charge/discharge completion time may include, but is not limited to, eliminating the charge/discharge completion time that is too large or too small and normalizing the obtained charge/discharge completion time to reduce the difference between values of the charge/discharge completion time calculated at different moments.

In this example, the impedance information of the battery pack is calculated in real time based on the data acquired by the voltage sensor and the current sensor, and the temperature information of the battery pack is determined based on the temperature information acquired by the temperature sensor. In this manner, the impedance curve of the battery pack can be updated based on the impedance information and temperature information acquired in real time so that the determined voltage variation curve of the battery pack is more accurate. At the same time, the maximum chemical capacity of the battery pack is updated according to the current data acquired by the current sensor and the DoD so that the maximum chemical capacity of the battery pack is more accurate, which is conducive to further improving the accuracy of the charge/discharge completion time of the battery pack.

Optionally, FIG. 7 is a block diagram of another device for calculating the charge/discharge completion time of a battery pack according to an example of the present application. Referring to FIG. 7, the device for calculating the charge/discharge completion time of a battery pack includes a DoD determination module 410, an impedance curve update module 411, a voltage variation curve determination module 420, a charge/-discharge endpoint determination module 430, a maximum chemical capacity update module 431, and a charge/discharge completion time determination module 440.

The DoD determination module 410 is used for calculating the DoD of the battery pack in real time based on the data acquired by a voltage sensor and a current sensor.

The impedance curve update module 411 is used for calculating the impedance information of the battery pack in real time based on the data acquired by the voltage sensor and the current sensor, determining the temperature information of the battery pack based on the temperature information acquired by the temperature sensor, and updating the impedance curve of the battery pack based on the impedance information and temperature information acquired in real time.

The voltage variation curve determination module 420 is used for determining a voltage variation curve of the battery pack based on an impedance curve and the DoD of the battery pack.

The charge/discharge endpoint determination module 430 is used for determining the DoD of the battery pack at the charge/discharge endpoint according to the voltage variation curve and the charge/discharge cut-off voltage of the battery pack.

The maximum chemical capacity update module 431 is used for updating the maximum chemical capacity $Q_{max}$ of the battery pack according to the current data acquired by the current sensor and the DoD.

The charge/discharge completion time determination module 440 is used for calculating the charge/-discharge completion time of the battery pack according to the first calculation formula.

The device for calculating the charge/discharge completion time of a battery pack provided in the example of the present application can perform the method for calculating the charge/discharge completion time of a battery pack provided in the preceding example and has functional modules and beneficial effects corresponding to the performed method. For the similarities, reference may be made to the preceding description.

In an example, the calculation device shown in FIGS. 4 and 7 is disposed in the battery pack 1. For example, the calculation device is the first controller 12, and the first controller 12 is communicatively connected to a detection assembly 11 in the battery pack. For example, the first controller 12 is communicatively connected to the voltage sensor and the current sensor in the battery pack to acquire the voltage and current data. Other information, such as the relationship table between the open-circuit voltage and the DoD, as well as the charge/discharge cut-off voltage, may also be pre-stored in the memory of the battery pack 1.

In another example, the calculation device shown in FIGS. 4 and 7 is disposed in the body 2 coupled to the battery pack 1. For example, the calculation device is the second controller 21. The body 2 may be a device that discharges the battery pack 1, such as a power tool, a lamp, or an energy station, or a device that charges the battery pack 1, such as a charger or an adapter. The body 2 includes the body housing 24 and the battery pack interface 23 disposed on the body housing. The battery pack interface 23 is used for connecting the battery pack 1. Optionally, the body includes the detection assembly 11 communicatively connected to the second controller 21 of the body 2. The detection assembly 11 may include the current sensor for detecting the current flowing into or out of the battery pack. Specifically, the charger includes the current sensor for detecting the charge current that the charger supplies to the battery pack, and the power tool includes the current sensor for detecting the discharge current that the tool draws from the battery pack. Optionally, the second controller 21 of the body 2 can be communicatively connected to the detection assembly 11 in the battery pack 1. The battery pack 1 sends the data detected by the detection assembly 11 in the battery pack to the body 2 through the power tool interface 13 and the battery pack interface 23. For example, the battery pack 1 sends the voltage data detected by the voltage sensor and the temperature data detected by the temperature sensor to the second controller 21 of the body 2. Other information, such as the relationship table between the open-circuit voltage and the DoD, as well as the charge/-discharge cut-off voltage, may also be pre-stored in the memory of the body 2.

In some examples, the body 2 may store relevant information of different types of battery packs or cells and perform matching when the battery pack is inserted, thereby calculating values of the charge/discharge completion time based on different types of battery packs. That is to say, an electrical device system formed by the battery pack 1 and the body 2, such as a power tool system formed by the battery pack and the power tool or a charging system formed by the battery pack and the charger, can also use the method for calculating the charge/discharge completion time of a battery pack provided in the preceding examples to calculate the charge/discharge completion time of the battery pack.

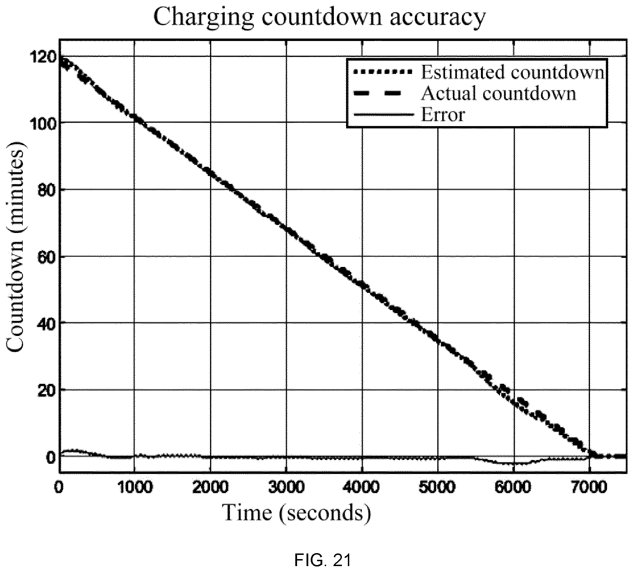

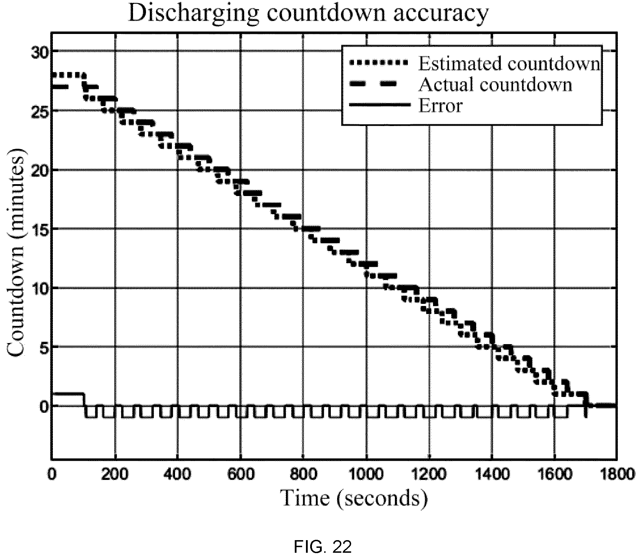

FIG. 21 shows a method for calculating the charge/discharge completion time of a battery pack provided in the preceding examples and performed by a calculation device and is a result graph illustrating the estimated charging completion time of the battery pack and the actual charging completion time of the battery pack. FIG. 22 shows a method for calculating the charge/discharge completion time of a battery pack provided in the preceding examples and performed by a calculation device and is a result graph illustrating the estimated discharging completion time of the battery pack and the actual discharging completion time of the battery pack.

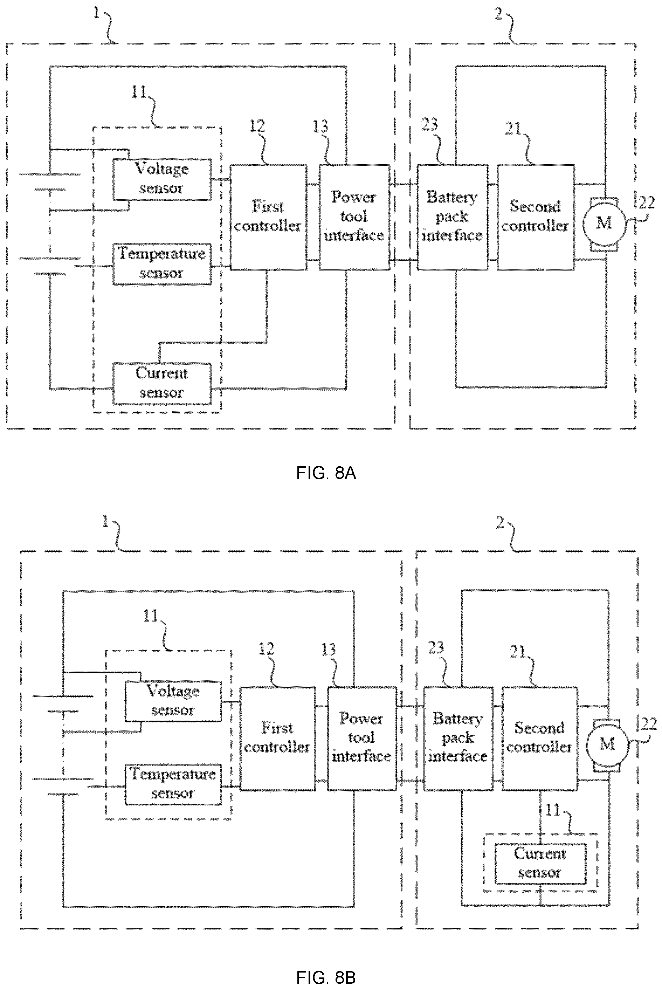

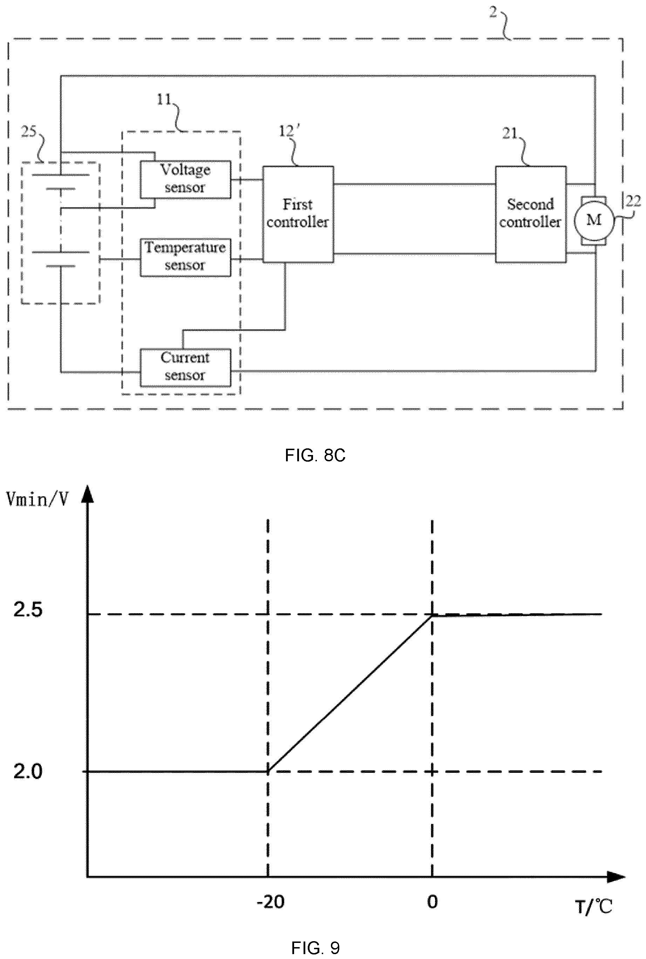

FIGS. 8A to 8C are each a block diagram of an electrical device system, specifically a power tool system, according to an example of the present application. Referring to FIGS. 8A and 8B, the power tool system includes the battery pack 1 and the power tool 2 that are electrically connected. Referring to FIG. 8C, the power tool system may further include the power tool 2 and a cell module 25 built into the power tool 2.

As shown in FIG. 8A, the battery pack 1 includes the detection assembly 11, the power tool interface 13, and the first controller 12. The detection assembly 11 is used for detecting the state parameter of the battery pack 1. The detection assembly 11 and the power tool interface 13 are both connected to the first controller 12. The first controller 12 is configured to determine the discharge capability parameter of the battery pack according to the state parameter and send the discharge capability parameter to the power tool interface 13.

The power tool 2 includes the battery pack interface 23 and the second controller 21. The battery pack interface 23 is coupled to the power tool interface 13. The battery pack interface 23 is used for receiving the discharge capability parameter transmitted by the power tool interface 13. The second controller 21 is connected to the battery pack interface 23. The second controller 21 is configured to control the working state of the power tool system according to the discharge capability parameter.

Based on the same concept, the present application further provides the battery pack 1. The battery pack 1 includes the housing 14, the detection assembly 11, the first controller 12, and the power tool interface 13. The detection assembly 11 is disposed in the housing 14. The detection assembly 11 is used for detecting the state parameter of the battery pack 1. The first controller 12 is communicatively connected to the detection assembly 11. The first controller 12 is configured to determine the discharge capability parameter of the battery pack 1 according to the state parameter. The power tool interface 13 is electrically connected to the first controller 12. The power tool interface 13 is used for connecting the power tool 2 to send the discharge capability parameter to the power tool 2.

The battery pack 1 can be electrically connected to the power tool 2 so that the battery pack 1 can supply power to the power tool 2.

Based on the same concept, the present application further provides the power tool 2. The power tool 2 includes an energy storage device, the detection assembly 11, and the second controller 21. The detection assembly 11 is used for detecting the state parameter of the energy storage device. The second controller 21 is communicatively connected to the detection assembly 11. The second controller 21 is configured to determine the discharge capability parameter of the energy storage device according to the state parameter and control the working state of the power tool 2 according to the discharge capability parameter. As shown in FIG. 8A, in an optional example, the energy storage device includes the detachable battery pack 1, the detection assembly 11 is disposed in the housing 14 of the battery pack, the state parameter acquired by the detection assembly 11 is sent to the second controller 21 by the first controller 12 through the battery pack interface 23 and the power tool interface 13, and the second controller 21 is configured to determine the discharge capability parameter of the energy storage device according to the state parameter and control the working state of the power tool 2 according to the discharge capability parameter.

As shown in FIG. 8B, in an optional example, the energy storage device includes the detachable battery pack 1, the detection assembly 11 is partially disposed in the housing 14 of the battery pack 1 and partially disposed in the body housing 24 of the power tool 2, the state parameter acquired by the detection assembly 11 disposed in the housing 14 of the battery pack 1 is sent to the second controller 21 by the first controller 12 through the battery pack interface 23 and the power tool interface 13, the state parameter acquired by the detection assembly 11 disposed in the body housing 24 of the power tool 2 is directly sent to the second controller 21, and the second controller 21 is configured to determine the discharge capability parameter of the energy storage device according to the state parameter and control the working state of the power tool 2 according to the discharge capability parameter.

As shown in FIG. 8C, in other examples, the energy storage device may further include the cell module 25 built into the body housing 24 of the power tool. A first controller 12' and the second controller 21 are also both disposed in the body housing 24 of the power tool 2 and can communicate with each other. In this example, the first controller 12' may be understood as the power management board of the power tool 2, and the second controller 21 may be understood as the power control board of the power tool 2. Further, the first controller 12' and the second controller 21 may each be a single controller into which the preceding functions are integrated. The detection assembly 11 is also disposed in the body housing 24 of the power tool 2 and is used for detecting the state parameter of the cell module 25 and sending the state parameter to the first controller 12' or the second controller 21. The first controller 12' or the second controller 21 is configured to determine the discharge capability parameter of the energy storage device according to the state parameter, and the second controller 21 controls the working state of the power tool 2 according to the discharge capability parameter calculated by the second controller 21 or acquired from the first controller 12'.

To sum up, the detection assembly 11 may be entirely disposed in the battery pack 1, or partially disposed in the battery pack 1 and partially disposed in the power tool 2, or entirely disposed in the power tool 2. Specifically, the state parameter includes the voltage, current, and temperature of the battery (that is, the battery pack 1 or the cell module 25). The detection assembly 11 includes the voltage sensor, the current sensor, and the temperature sensor. Optionally, the voltage sensor and the temperature sensor are disposed in the battery pack 1, and the current sensor is disposed in the power tool 2. The step of determining the discharge capability parameter of the energy storage device according to the state parameter acquired by the detection assembly 11 may be performed by the first controller 12 or the second controller 21. The first controller 12 may transmit the calculated discharge capability parameter to the second controller 21 and may also transmit the original or filtered voltage, current, and temperature data to the second controller 21.

The discharge capability parameter includes at least one of a first discharge capability parameter and a second discharge capability parameter. The first discharge capability parameter includes the discharge capability of the battery pack 1 when the battery pack 1 is controlled to be discharged instantaneously until the voltage of the battery pack 1 satisfies a cut-off condition. The second discharge capability parameter includes the discharge capability of the battery pack 1 when the battery pack 1 is controlled to be discharged continuously until the voltage of the battery pack 1 satisfies the cut-off condition.

In other examples, when the energy storage device includes the cell module 25, the discharge capability parameter includes at least one of the first discharge capability parameter and the second discharge capability parameter. The first discharge capability parameter includes the discharge capability of the cell module 25 when the cell module 25 is controlled to be discharged instantaneously until the voltage of the cell module 25 satisfies a cut-off condition. The second discharge capability parameter includes the discharge capability of the cell module 25 when the cell module 25 is controlled to be discharged continuously until the voltage of the cell module 25 satisfies the cut-off condition. It is to be noted that, since the first controller of the cell module 25 has the same function as the first controller of the battery pack, unless otherwise specified, the following description is made using the energy storage module including the battery pack as an example.

It is to be noted that the discharge capability parameter includes at least one of the first discharge capability parameter and the second discharge capability parameter, which may be understood as that the discharge capability parameter includes the first discharge capability parameter, or the discharge capability parameter includes the second discharge capability parameter, or the discharge capability parameter includes the first discharge capability parameter and the second discharge capability parameter.

The cut-off condition may be understood as a condition in which the battery pack 1 stops being discharged. In some examples, the discharging cut-off condition may be that the DoD of the battery pack 1 is less than or equal to the minimum DoD allowed by the battery pack 1. In some examples, the discharging cut-off condition may be that the voltage of the battery pack 1 is less than or equal to the minimum voltage allowed by the battery pack 1. Controlling the battery pack 1 to be discharged instantaneously until the voltage of the battery pack 1 satisfies the cut-off condition may be understood as obtaining through state estimation that the battery pack 1 is discharged instantaneously from the current state to the state of the battery pack 1 that satisfies the cut-off condition. For example, the battery pack 1 is discharged within 1s from the current state to the state of the battery pack 1 that satisfies the cut-off condition. Controlling the battery pack 1 to be discharged continuously until the voltage of the battery pack 1 satisfies the cut-off condition may be understood as obtaining through state estimation that the battery pack 1 is discharged continuously from the current state to the state of the battery pack 1 that satisfies the cut-off condition. For example, the battery pack 1 is discharged within 10s from the current state to the state of the battery pack 1 that satisfies the cut-off condition.

In an optional example, the discharge capability parameter of the battery pack 1 includes a current limit value or a power limit value, that is, the maximum current or maximum power that the battery pack 1 can output, thereby making the basis for controlling the power tool 2 simpler.

The detection assembly 11, the first controller 12, and at least part of the power tool interface 13 are disposed in the housing 14 of the battery pack 1, and the housing 14 is used for protecting the components disposed in the housing 14. The detection assembly 11 may include, but is not limited to, the current sensor, the voltage sensor, the temperature sensor, and the like so that the detection assembly 11 may be used for detecting the state parameter of the battery pack. In an optional example, the state parameter of the battery pack may include, but is not limited to, at least one of the current information, the voltage information, and the temperature information of the battery pack 1.

The power tool interface 13 is electrically connected to the first controller 12 and is also coupled to the power tool 2. Specifically, the power tool interface 13 is electrically connected to the battery pack interface 23 of the power tool 2. The power tool interface 13 is used for sending the discharge capability parameter of the battery pack 1 to the battery pack interface 23 of the power tool 2. The battery pack interface 23 of the power tool 2 is connected to the second controller 21 so that the second controller 21 can control the working state of the power tool according to the discharge capability parameter received by the battery pack interface 23.

The power tool 2 includes an electric motor 22, and controlling the working state of the power tool 2 may include, but is not limited to, controlling the current of the electric motor 22 in the power tool 2 to be less than the current limit value or controlling the power of the electric motor 22 in the power tool 2 to be less than the power limit value.

In this example, the first controller is configured to determine the discharge capability parameter of the battery pack according to the state parameter of the battery pack, where the discharge capability parameter includes at least one of the first discharge capability parameter and the second discharge capability parameter so that the discharge capability of the battery pack is determined according to the state parameter of the battery pack. In this manner, under the premise that the power of the battery pack is fully used to give full play to the capability of the battery pack, excessive power usage of the battery pack can be prevented, thereby improving the service life and safety performance of the battery pack.

In an example, when the state parameter includes the current information, the voltage information, and the temperature information, the first controller 12 is specifically configured to calculate the SoC of the battery pack 1 according to the current information and the voltage information, determine the instantaneous DC resistance and/or continuous DC resistance of the battery pack 1 according to the SoC and the temperature information, determine the first discharge capability parameter according to the cut-off condition and the instantaneous DC resistance of the battery pack 1, and/or determine the second discharge capability parameter according to the cut-off condition and the continuous DC resistance.

The current information may include the current of the battery pack 1 acquired in real time by the detection assembly 11. The voltage information may include the open-circuit voltage of the battery pack 1 before discharge acquired by the detection assembly 11, thereby calculating the SoC of the battery pack 1 in an ampere-hour integral method.

The instantaneous DC resistance of the battery pack 1 may be understood as the DC resistance of the battery pack 1 when the battery pack 1 is controlled to be discharged instantaneously from the current state until the state of the battery pack satisfies the cut-off condition. The continuous DC resistance of the battery pack 1 may be understood as the DC resistance of the battery pack 1 when the battery pack 1 is controlled to be discharged continuously from the current state until the state of the battery pack 1 satisfies the cut-off condition.

In an optional example, the step of determining the instantaneous DC resistance and/or continuous DC resistance of the battery pack 1 according to the SoC and the temperature information may include: obtaining the instantaneous DC resistance and/or continuous DC resistance of the battery pack 1 according to the temperature information and the SoC in a table lookup method.

In some examples, the first discharge capability parameter and the second discharge capability parameter each include the current limit value, and the step of determining the first discharge capability parameter according to the cut-off condition and the instantaneous DC resistance of the battery pack 1 includes: determining the instantaneous voltage before discharge of the battery pack 1 according to the current information, and determining the instantaneous discharge current limit value of the battery pack 1 according to the instantaneous voltage before discharge, the cut-off condition, and the instantaneous DC resistance of the battery pack.

The instantaneous voltage before discharge of the battery pack 1 may be understood as the voltage of the battery pack at the moment before discharge, for example, the voltage within 1s before discharge.

In some examples, the first discharge capability parameter and the second discharge capability parameter each include the current limit value, and the step of determining the second discharge capability parameter according to the cut-off condition and the continuous DC resistance includes: determining the continuous voltage before discharge of the battery pack 1 according to the current information, and determining the continuous discharge current limit value of the battery pack 1 according to the continuous voltage before discharge, the cut-off condition, and the continuous DC resistance.

The continuous voltage before discharge of the battery pack 1 may be understood as the voltage that the battery pack 1 maintains before discharge, for example, the average voltage of the battery pack 1 within 10s before discharge.

In some examples, the cut-off condition includes the cut-off voltage. The cut-off voltage is determined according to the lowest temperature of the battery pack 1.

The cut-off voltage may be understood as the minimum voltage allowed by the battery pack 1, that is, the minimum voltage that the battery pack 1 can output normally. The lowest temperature of the battery pack 1 may be understood as the lowest temperature measured at each measurement point in the battery pack 1. It is to be noted that the cut-off voltage may be set to different values according to the temperature of the battery pack 1. The relationship between the cut-off voltage of the battery pack 1 and the temperature of the battery pack 1 may be expressed by one or more curves.

In an exemplary example, as shown in FIG. 9, when the temperature of the battery pack 1 is greater than 0°C, the cut-off voltage Vmin of the battery pack 1 may be set to 2.5 V. When the temperature of the battery pack 1 is less than minus 20°C, the cut-off voltage Vmin of the battery pack 1 may be set to 2 V. When the temperature of the battery pack 1 is greater than minus 20°C and less than 0°C, the cut-off voltage Vmin of the battery pack 1 transitions smoothly from 2 V to 2.5 V as the temperature rises. It is to be noted that FIG. 9 only exemplarily shows that when the temperature of the battery pack 1 is greater than minus 20°C and less than 0°C, the cut-off voltage of the battery pack 1 transitions linearly and smoothly from 2 V to 2.5 V as the temperature rises. In other examples, the cut-off voltage of the battery pack 1 may transition nonlinearly or non-smoothly from 2 V to 2.5 V as the temperature rises. This example does not specifically limit the type of the smooth transition of the cut-off voltage of the battery pack 1.

In some examples, if the instantaneous voltage before discharge or the continuous voltage before discharge is lower than the cut-off voltage, the battery pack is controlled to stop discharging, that is, the power tool 2 is controlled to shut down, thereby protecting the power tool 2 and extending the service life of the power tool 2.

In some examples, controlling the power tool 2 to shut down includes controlling the power tool 2 to shut down after a preset time period according to the current information, which is conducive to improving the operating feel of the power tool 2.

The preset time period may be set according to the current information. If the current value of the battery pack 1 is greater than I1, the preset time period may be set to t1. If the current value of the battery pack is less than I2, the preset time period may be set to t3. If the current value of the battery pack 1 is less than I1 and greater than I2, the preset time period may be set to t2. I1 > I2, and t1 < t2 < t3.

In some examples, if the instantaneous voltage before discharge or the continuous voltage before discharge is not lower than the cut-off voltage, current limiting protection is performed on the power tool system according to the temperature parameter. It is to be understood that current limiting performed on the power tool system may include current limiting protection performed on the battery pack or current limiting protection performed on the power tool.

The current limiting protection performed on the power tool system according to the temperature parameter may be understood as determining the cut-off voltage of the battery pack 1 according to the temperature parameter, determining the discharge capability parameter of the battery pack 1, and then controlling the working state of the power tool 2 according to the discharge capability parameter of the battery pack 1.

In some examples, the battery pack 1 further performs under-temperature or over-temperature protection based on the temperature information. That is, when the temperature of the battery pack 1 is within a preset temperature range, the working state of the power tool 2 is controlled according to the current limit value; and when the temperature of the battery pack 1 is not within the preset temperature range, the current value outputted by the battery pack 1 to the power tool 2 is further limited, thereby maximizing the capability of the battery pack 1 while protecting the battery pack 1.

The preset temperature range is set according to a temperature range in which the battery pack 1 can work normally. In an exemplary example, the preset temperature range is [-20°C, 70°C].

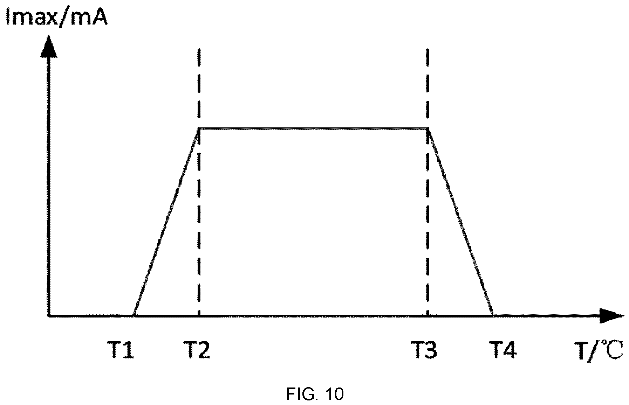

In an exemplary example, as shown in FIG. 10, when the temperature of the battery pack is less than minus T1 or greater than T4, the current limit value $I_{max}$ of the battery pack is 0 mA, that is, the battery pack 1 is prohibited from being discharged. When the temperature of the battery pack 1 is within [T2, T3], that is, the temperature of the battery pack 1 is within the preset temperature range, the current value of the battery pack 1 is controlled according to the determined discharge capability parameter of the battery pack 1. When the temperature of the battery pack 1 is within [T1, T2] or [T3, T4], the current value of the battery pack 1 is limited to transitioning smoothly between 0 and the determined current limit value. In an exemplary example, the smooth transition is adopted between -30°C to -20°C and between 70°C to 80°C, for example, multiplying by a factor of proportionality that varies with temperature.

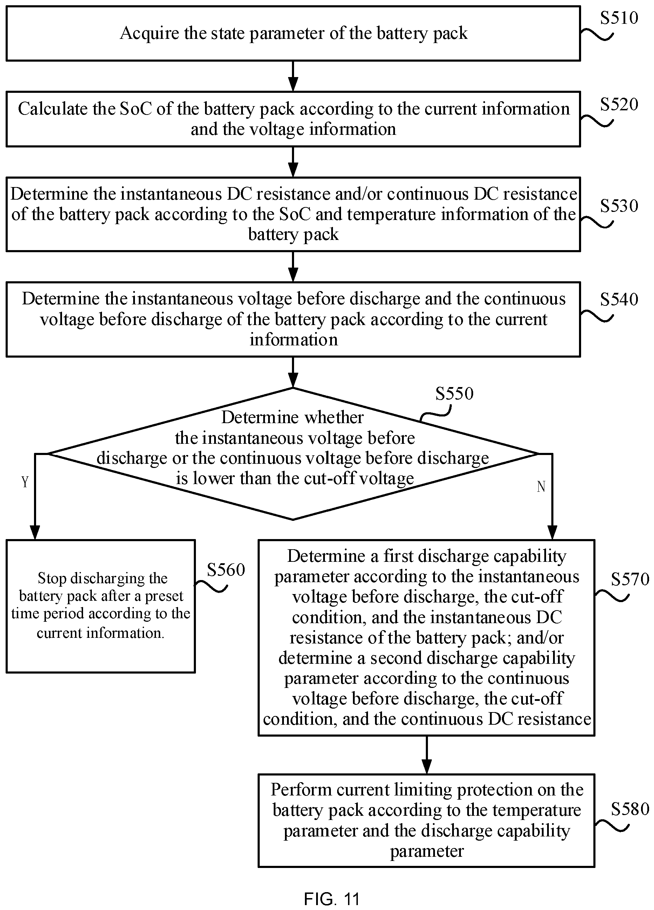

FIG. 11 is a flowchart of a method for determining a discharge capability parameter of a battery pack according to an example of the present application. Referring to FIG. 11, this example further provides a method for determining a discharge capability parameter of a battery pack. The method is specifically described below.

In S510, the state parameter of the battery pack is acquired.

The state parameter of the battery pack includes at least one of the current information, the voltage information, and the temperature information of the battery pack.

In S520, the SoC of the battery pack is calculated according to the current information and the voltage information.

In S530, the instantaneous DC resistance and/or continuous DC resistance of the battery pack are determined according to the SoC and temperature information of the battery pack.

In S540, the instantaneous voltage before discharge and the continuous voltage before discharge of the battery pack are determined according to the current information.

In S550, determine whether the instantaneous voltage before discharge or the continuous voltage before discharge is lower than the cut-off voltage. If so, S560 is performed; if not, S570 is performed.

In S560, stop discharging the battery pack after a preset time period according to the current information.

In S570, a first discharge capability parameter is determined according to the instantaneous voltage before discharge, the cut-off condition, and the instantaneous DC resistance of the battery pack; and/or a second discharge capability parameter is determined according to the continuous voltage before discharge, the cut-off condition, and the continuous DC resistance.

The discharge capability parameter includes at least one of the first discharge capability parameter and the second discharge capability parameter. The first discharge capability parameter includes the discharge capability of the battery pack when the battery pack is controlled to be discharged instantaneously until the state of the battery pack satisfies a cut-off condition. The second discharge capability parameter includes the discharge capability of the battery pack when the battery pack is controlled to be discharged continuously until the state of the battery pack satisfies the cut-off condition. The first discharge capability parameter and the second discharge capability parameter each include the current limit value or the power limit value.

In S580, current limiting protection is performed on the battery pack according to the temperature parameter and the discharge capability parameter.

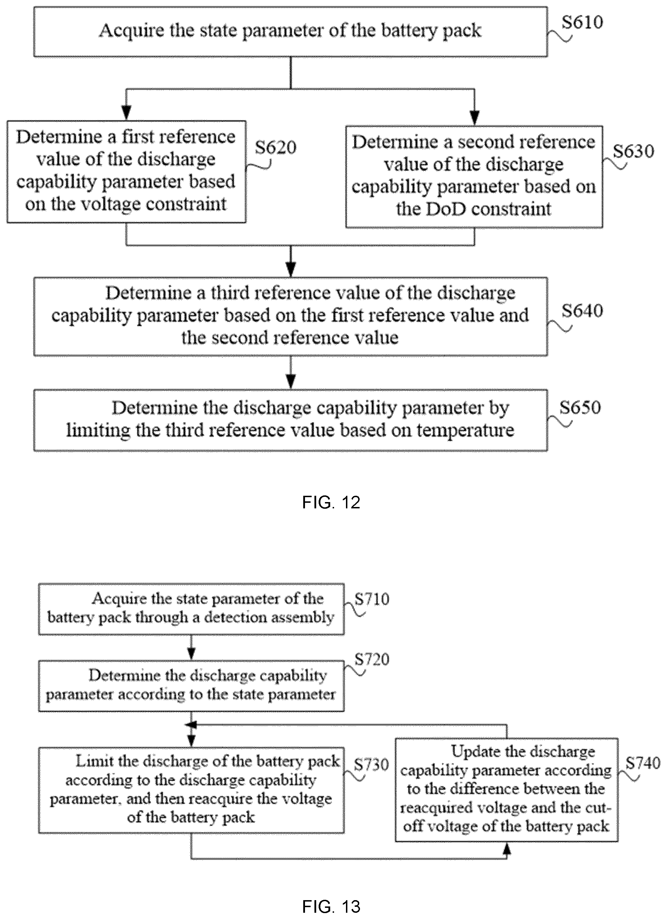

FIG. 12 is a flowchart of another method for determining a discharge capability parameter of a battery pack according to an example of the present application. Referring to FIG. 12, this example further provides another method for determining a discharge capability parameter of a battery pack, and the method may be used for determining the first discharge capability parameter and/or the second discharge capability parameter, that is, the value of the instantaneous discharge capability parameter and/or the value of the continuous discharge capability parameter, for example, the current limit value that satisfies the target continuous discharge time (if the target continuous discharge time is set to be short and less than or equal to a first time threshold, such as 1s or 3s, the current limit value is the first discharge capability parameter; and if the target continuous discharge time is set to be long and greater than the first time threshold, such as 10s or 30s, the current limit value is the second discharge capability parameter). The details are described below.

In S610, the state parameter of the battery pack is acquired.

The state parameter of the battery pack includes at least one of the current information, the voltage information, and the temperature information of the battery pack. The state parameter of the battery pack may be acquired by the detection assembly. As described above, the detection assembly may be partially or completely disposed in the battery pack or the power tool, and the details are not repeated here.

In S620, a first reference value of the discharge capability parameter is determined based on the voltage constraint.

The first reference value is determined according to the open-circuit voltage and resistance of the battery pack according to Ohm's law. Specifically, the current DoD of the battery pack is calculated based on the current and the voltage. According to the current DoD, the current open-circuit voltage and instantaneous DC resistance corresponding to the current DoD may be obtained by, for example, a lookup table. The maximum instantaneous discharge current may be calculated through the current open-circuit voltage, the cut-off voltage, and the instantaneous DC resistance. Similarly, the DoD after the target continuous discharge time in the current working condition is predicted so that the open-circuit voltage and continuous DC resistance after the target continuous discharge time can be obtained by, for example, a lookup table. The maximum continuous discharge current may be calculated through the open-circuit voltage and continuous DC resistance after the target continuous discharge time. As described above, the relationship table between the open-circuit voltage and the DoD may be stored in the battery pack. In an example, the method in the present application may be adopted to adaptively learn and update the impedance curve, thereby querying more accurate instantaneous DC resistance and continuous DC resistance.

In S630, a second reference value of the discharge capability parameter is determined based on the DoD constraint.

The second reference value is determined based on the definition of the capacity of the battery pack according to the remaining capacity of the battery pack and the target discharge duration. Specifically, the SoC of the battery pack is calculated according to the current and the voltage; and then the remaining capacity of the battery pack is acquired according to the SoC and the maximum chemical capacity of the aged battery pack. According to the remaining capacity of the battery pack and the set target discharge duration, the maximum instantaneous discharge current and the maximum continuous discharge current of the battery pack may be calculated. In an example, the method in the present application may be adopted to learn and update the maximum chemical capacity of the battery pack when conditions permit.

In S640, a third reference value of the discharge capability parameter is determined based on the first reference value and the second reference value.

The third reference value is calculated in conjunction with the first reference value and the second reference value in a mathematical statistical method. In an example, the third reference value is the smaller one of the first reference value and the second reference value. In an example, the third reference value is the average of the first reference value and the second reference value. In an example, the third reference value is the smaller one of the first reference value and the second reference value plus an adjustment amount. In an example, the third reference value is the average of the first reference value and the second reference value minus an adjustment amount. Many specific calculation methods exist. Experimental sampling may be performed on specific power tools and appropriate statistical methods may be selected. The details are not repeated here.

In S650, the discharge capability parameter is determined by limiting the third reference value based on temperature.

Referring to the principle illustrated in FIG. 10, when the temperature of the battery pack is within [T1, T2] or [T3, T4], the discharge capability parameter of the battery pack is limited to transitioning smoothly between 0 and the third reference value, for example, by performing proportional limiting. It is to be understood that the temperature of the battery pack may mainly refer to the temperature of the cells. The temperature of the cell may refer to the surface temperature of the cell or the internal temperature of the cell. The surface temperature of the cell may be measured by a temperature measuring element (for example, a negative-temperature-coefficient (NTC) temperature sensor), and the internal temperature of the cell may be calculated through the recursive algorithm using the formula for the heat conduction effect. The temperature of the battery pack may be based on the temperature of the hottest cell or based on other statistical methods such as the average temperature of the cells.

After the preceding steps, the discharge capability parameter of the current battery pack may be determined. For example, the discharge capability parameter includes the maximum instantaneous discharge current and/or the maximum continuous discharge current. The power tool may control the discharge of the battery pack according to the discharge capability parameter. It is to be understood that the preceding steps are a schematic combination. Based on the learned capacity of the aged battery and internal resistance, the maximum instantaneous and continuous discharge capability estimation is performed in conjunction with the DoD constraint, the cut-off voltage constraint, the sampling temperature constraint, and the estimated battery internal temperature constraint of the battery. In some examples, those skilled in the art may also remove some of the preceding steps, for example, removing S650, that is, the effect of the temperature of the battery pack on the discharge capability of the current battery pack is not considered, and the discharge capability of the battery pack is calculated just based on the current and voltage of the battery pack. For another example, the discharge capability parameter may be determined only based on the first reference value calculated by the voltage constraint or on the second reference value calculated by the discharge depth constraint, instead of comprehensively selecting the reference values calculated by the two constraints.

In an example, accuracy compensation may be performed on the discharge capability parameter of the battery pack according to the concept of closed-loop control. Referring to FIG. 13, the present application further provides a method for determining a discharge capability parameter of a battery pack. The method includes the steps below.

In S710, the state parameter of the battery pack is acquired through a detection assembly.

The state parameter of the battery pack includes at least one of the current information, the voltage information, and the temperature information of the battery pack. The state parameter of the battery pack may be acquired by the detection assembly. As described above, the detection assembly may be partially or completely disposed in the battery pack or the power tool, and the details are not repeated here.

In S720, the discharge capability parameter is determined according to the state parameter.

In this step, the discharge capability parameter of the battery pack may be determined with reference to the preceding method from S610 to S650 or other methods. The discharge capability parameter includes at least one of a first discharge capability parameter and a second discharge capability parameter; the first discharge capability parameter is the discharge capability of the battery pack when the battery pack is controlled to be discharged instantaneously to the cut-off voltage; and the second discharge capability parameter is the discharge capability of the battery pack when the battery pack is controlled to be discharged continuously to the cut-off voltage. For example, the discharge capability parameter includes the maximum instantaneous discharge current and/or the maximum continuous discharge current.

In S730, the discharge of the battery pack is limited according to the discharge capability parameter, and then the voltage of the battery pack is reacquired.

In this step, the power tool controls the discharge of the battery pack using the discharge capability parameter determined in S720 as a limit value, and then reacquires the voltage of the battery pack. In actual situations, common parameters such as the voltage, current, and temperature of the battery pack are generally continuously detected and acquired by the detection assembly. The reacquired voltage here may not only be a single detection result but also a statistical result of the detection results over a period of time. The reacquired voltage is the current terminal voltage of the battery pack after a certain period of control according to the discharge capability parameter determined in step S720.

In S740, the discharge capability parameter is updated according to the difference between the required voltage and the cut-off voltage of the battery pack.

Specifically, the discharge capability parameter is adjusted according to the difference between the current terminal voltage and the cut-off voltage, and also the internal resistance of the battery pack. When the current terminal voltage is greater than the cut-off voltage, it means that the previously determined discharge capability parameter is conservative, that is to say, the discharge capability parameter, such as the maximum instantaneous discharge current and/or the maximum continuous discharge current, may be increased, and the specific compensation value is calculated according to the difference between the current terminal voltage and the cut-off voltage and the internal resistance of the battery pack. When the current terminal voltage is less than the cut-off voltage, it means that the previously determined discharge capability parameter is optimistic, that is to say, the discharge capability parameter, such as the maximum instantaneous discharge current and/or the maximum continuous discharge current, may be decreased, and the specific compensation value is calculated according to the difference between the current terminal voltage and the cut-off voltage and the internal resistance of the battery pack.

During the actual use of the power tool, it is not necessary to discharge the battery pack at the maximum capacity. In an example, the following may be further performed: timing the working condition in which discharging is performed when the discharge capability parameter is not reached, and determining the weight of the compensation value according to the timing condition. For example, when the proportion of working conditions in which discharging is not performed according to the discharge capability parameter is relatively large, the weight of the compensation value is reduced. As shown in FIG. 13, S730 and S740 may be performed in multiple cycles, thereby compensating and updating the discharge capability parameter in real time. The preceding method for determining the discharge capability parameter may be performed by the first controller 12 of the battery pack 1 or the second controller 21 of the power tool 2.

The present application further provides a new concept of the SoC. The conventional definition of SoC is the ratio of the remaining capacity of a battery used for a period or unused for a long time to the capacity of the battery in a fully charged state and is usually expressed as a percentage. The value range of the SoC is from 0 to 1. When the SoC is equal to 0, it means that the battery is fully discharged. When the SoC is equal to 1, it means that the battery is fully charged. Conventionally, the sum of the SoC and the DoD is 1. That is to say, when the DoD is 60%, the SOC is 40%; and when the DoD is 40%, the SoC is 60%. The capacity in the fully charged state refers to the maximum chemical capacity of the battery. The maximum chemical capacity does not include the capacity that the battery has lost during the aging process. Therefore, even if the battery has aged, for example, the maximum chemical capacity is only 80% of the initial chemical capacity, when the battery is fully charged, the SoC can still reach 1. However, not in all working conditions can the maximum chemical capacity of the battery be fully discharged. That is to say, when using some electrical devices such as power tools, users may find that even if the state of charge (SoC) is not 0, the electrical devices can no longer draw current from the battery pack. In particular, when used by some power tools with high discharge current, such as chain saws and snow blowers, the conventional SoC of the battery pack cannot be completely discharged to 0. Therefore, the SoC with the conventional definition may sometimes cause confusion or trouble to the users, making it impossible for the users to reasonably evaluate the power requirements of the electrical devices that need to be used such as power tools.

To solve this problem, the present application proposes the concept of the RSoC. The RSoC is defined as the ratio of the remaining discharge capacity of the battery in the current working condition to the maximum capacity that can be discharged by the battery in the current working condition (the maximum discharge capacity). The remaining discharge capacity of the battery in the current working condition is the difference between the maximum capacity that can be discharged by the battery in the current working condition (the maximum discharge capacity) and the capacity that has been discharged (the accumulated discharge capacity). Alternatively, the RSoC may be defined as the ratio of the remaining DoD of the battery in the current working condition to the DoD of the battery at the discharge endpoint in the current working condition, where the remaining DoD of the battery in the current working condition is the difference between the DoD of the battery at the discharge endpoint in the current working condition and the DoD of the battery at the current moment.

Theoretically, not only can the RSoC in the current working condition be calculated during discharging, but also the RSoC at the current charge current/rate can be calculated during charging. However, the charging device often adjusts the charge current/rate according to the charging state of the battery pack, while the discharging device mainly performs discharging according to the requirements of the discharge operation. The RSoC of the battery pack is estimated during discharging so that the device that uses the electrical energy of the battery pack, such as the power tool, can optimize the discharging process in conjunction with the current working condition and the RSoC. In an example, the RSoC of the battery pack may be provided to the user through the battery pack, a display device on the electrical device, or a mobile terminal such as a mobile phone so that the user can reasonably evaluate the power requirements and carry a sufficient number of battery packs.

Based on the same concept, the present application further provides a method for estimating an RSoC of a battery pack. The battery pack 1 includes the housing 14, multiple cells 15 accommodated in the housing 14, the power tool interface 13 disposed on the housing 14, and the first circuit board 16 accommodated in the housing 14 and electrically connected to the power tool interface 13, where the first controller 12 is disposed on the first circuit board 16. The estimation method includes: acquiring the voltage and the current of the battery pack 1 through the detection assembly 11; determining the current DoD of the battery pack 1 based on the voltage and the current of the battery pack 1; determining the endpoint DoD of the battery pack 1 in the current working condition based on the voltage, the current, and the current DoD of the battery pack 1; and calculating the RSoC of the battery pack 1 in the current working condition according to the current DoD and the endpoint DoD. In an example, the RSoC is the ratio of the difference between the endpoint DoD and the current DoD to the endpoint DoD. For the specific calculation processes of the current DoD, the endpoint DoD, and the intermediate variables, reference may be made to the description in other paragraphs of the present application. A brief description is made below. In an example, the step of determining the current DoD of the battery pack 1 based on the voltage and the current of the battery pack 1 includes: calculating the initial DoD based on the voltage of the battery pack 1 at rest; and calculating the current DoD based on the initial DoD, the maximum chemical capacity of the battery pack 1, and the current. In an example, the maximum chemical capacity of the battery pack 1 is determined based on the initial chemical capacity and the overall SoH of the battery pack 1. In an example, a moment when the voltage of the battery pack 1 reaches the discharge cut-off voltage is defined as a discharge endpoint, and the endpoint DoD is defined as the DoD corresponding to the voltage at the discharge endpoint. In an example, the step of determining the endpoint DoD of the battery pack 1 in the current working condition based on the voltage, the current, and the current DoD of the battery pack 1 includes: adaptively learning an impedance curve in the current working condition based on the voltage, the current, and the current DoD of the battery pack 1; determining a voltage variation curve of the battery pack 1 in the current working condition according to the impedance curve and the current DoD; and determining the endpoint DoD according to the voltage variation curve and the discharge cut-off voltage.

Based on the same concept, the present application further provides another method for estimating an RSoC of a battery pack. The battery pack 1 includes the housing 14, multiple cells 15 accommodated in the housing 14, the power tool interface 13 disposed on the housing 14, and the first circuit board 16 accommodated in the housing 14 and electrically connected to the power tool interface 13, where the first controller 12 is disposed on the first circuit board 16. The estimation method includes: acquiring the voltage and the current of the battery pack 1 through the detection assembly 11; acquiring the accumulated discharge capacity of the battery pack 1 based on the current and the voltage of the battery pack 1; acquiring the maximum discharge capacity of the battery pack 1 in the current working condition based on the voltage and the current of the battery pack 1; and calculating the RSoC of the battery pack 1 in the current working condition according to the accumulated discharge capacity and the maximum discharge capacity. In an example, the RSoC is the ratio of the difference between the maximum discharge capacity and the accumulated discharge capacity to the maximum discharge capacity. For the specific calculation process of the accumulated discharge capacity, the maximum discharge capacity, and the intermediate variables, reference may be made to the description in other paragraphs of the present application. A brief description is made below. In an example, the accumulated discharge capacity is the product of the maximum chemical capacity of the battery pack 1 and the current DoD of the battery pack 1. In an example, the maximum discharge capacity is the product of the maximum chemical capacity of the battery pack 1 and the endpoint DoD of the battery pack 1 in the current working condition.

Based on the same concept, the present application further provides an electrical device system that can simultaneously provide the conventional SoC and the RSoC of the battery pack. The electrical device system includes the battery pack 1 and the body 2. The body 2 may be the power tool 2, a lamp, an energy station, or the like. The battery pack 1 includes a housing 14, multiple cells 15 accommodated in the housing 14, a power tool interface 13 disposed on the housing 14, and a first circuit board 16 accommodated in the housing 14. The first controller 12 is disposed on the first circuit board 16. The body 2 includes the body housing 24, the battery pack interface 23 disposed on the body housing 24 and used for electrically and communicatively connecting the power tool interface 13, and the second circuit board 26 accommodated in the body housing 24 and electrically connected to the battery pack interface 23, where the second controller 21 is disposed on the second circuit board 26. The electrical device system further includes the detection assembly 11 used for detecting at least the voltage and the current of the battery pack 1 and disposed in the housing 14 of the battery pack and/or the body housing 24 of the body. The first controller 12 or the second controller 21 is communicatively connected to the detection assembly 11 and is configured to: acquire the voltage and the current of the battery pack 1 through the detection assembly 11; calculate the current DoD of the battery pack 1 based on the voltage and the current of the battery pack; determine the endpoint DoD of the battery pack 1 in the current working condition based on the voltage, the current, and the current DoD of the battery pack 1; and determine the SoC of the battery pack and the RSoC of the battery pack in the current working condition according to the current DoD and the endpoint DoD.

In a specific example, referring to FIGS. 8A to 8C, the detection assembly 11 may be entirely disposed in the battery pack 1, and the first controller 12 may calculate at least one of the SoC of the battery pack 1 and the RSoC of the battery pack 1 in the current working condition. The detection assembly 11 may be disposed in the battery pack 1 and the body 2 and uniformly transmit the detection data to the first controller 12 or the second controller 21, and the first controller 12 or the second controller 21 may calculate at least one of the SoC of the battery pack 1 and the RSoC of the battery pack 1 in the current working condition. As one of the expanded examples, the body 2 may be provided with electrical energy not by the battery pack 1 but by the cell module 25 built into the body 2, the first controller 12' and the detection assembly 11 are disposed in the body housing 24 of the body 2, and the first controller 12' or the second controller 21 calculates at least one of the SoC of the battery pack 1 and the RSoC of the battery pack 1 in the current working condition. In an example, the detection assembly 11 includes the voltage sensor, the current sensor, and the temperature sensor. Optionally, the voltage sensor and the temperature sensor are disposed in the battery pack 1, and the current sensor is disposed in the body 2.

Further, the preceding electrical device system may include a display device for displaying at least one of the SoC of the battery pack 1 and the RSoC of the battery pack 1 in the current working condition to the user. The display device may be disposed in the battery pack 1, the body 2, or a mobile terminal such as a mobile phone.

The present application further provides a method for calculating the maximum chemical capacity of a battery pack, which may be used by the preceding maximum chemical capacity update module 431. In the conventional method, the battery is fully charged and/or fully discharged, thereby acquiring the maximum charge/discharge capacity, that is, the maximum chemical capacity, of the battery in a complete charge and/or discharge cycle. In the conventional method, a stable current during the complete charge and/or discharge cycle is usually required, and the experimental conditions are relatively harsh and may not always be satisfied during the daily use of the users.

The maximum chemical capacity of the battery pack is equal to the product of the SoH and the initial chemical capacity. Since the initial chemical capacity of the battery pack is fixed, calculating the maximum chemical capacity is actually calculating the SoH of the battery pack. The present application believes that the overall SoH of the battery can be obtained by mapping from a preset mapping model according to the interval SoH of the battery. Therefore, the problem of determining the overall SoH of the battery can be simplified to determining the interval SoH of the battery. The interval SoH may be obtained by comparing the actual charge capacity within the preset voltage interval with the health assessment reference value. In an example, the health assessment reference value is the theoretical charge capacity of a brand new battery pack within the preset voltage interval. In an example, the interval SoH is equal to the ratio of the actual charge capacity to the theoretical charge capacity.

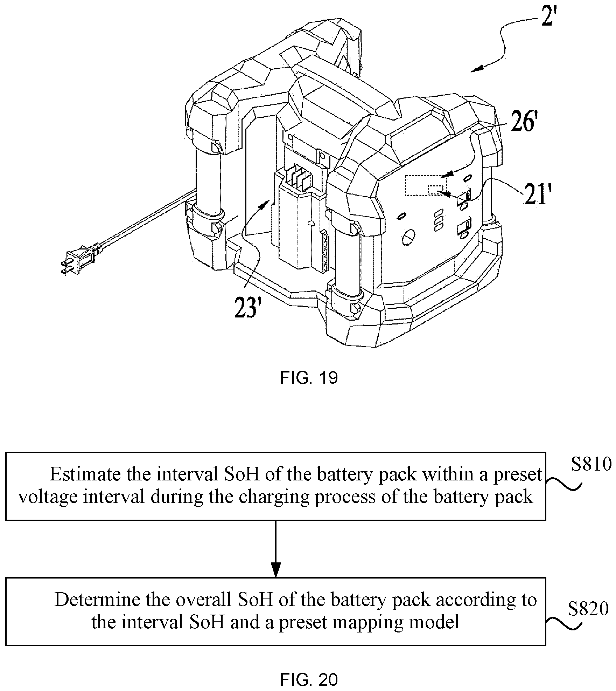

Based on the preceding concept, the present application provides a method for evaluating an SoH of a battery pack 1. The battery pack 1 includes the housing 14, multiple cells 15 accommodated in the housing 14, the power tool interface 13 disposed on the housing 14, and the first circuit board 16 accommodated in the housing 14 and electrically connected to the power tool interface 13, where the first controller 12 is disposed on the first circuit board 16. Referring to FIG. 20, the evaluation method includes the steps below.

In S810, the interval SoH of the battery pack within a preset voltage interval is estimated during the charging process of the battery pack.

When the charging process of the battery pack satisfies the conditions below, the interval SoH within the preset voltage interval may be estimated during this charging process.

1. After a preset time period since the start of charging, the voltage of the battery pack is less than the minimum value within the preset voltage interval. The preset time period may be a period that is long enough to ensure that the battery pack can enter a stable charging state, such as 100s, 200s, or 300s. Alternatively, in conjunction with the charge current, the preset time period may be 50s, 100s, or 200s from the moment when the charge current reaches the rated charge current. To sum up, the preset time period is a period that ensures that the battery pack can enter a stable charging state. If the voltage of the battery pack exceeds the minimum value within the preset voltage interval in the stable charging state, the actual charge capacity of the battery pack within the entire preset voltage interval cannot be calculated during this charging process. Therefore, the interval SoH cannot be calculated during this charging process.

2. After a preset time period since the start of charging, the temperature of the battery pack is within a preset temperature interval. The preset temperature interval here refers to a suitable normal temperature interval. The temperature cannot be too high or too low. If the temperature of the battery pack exceeds the preset temperature interval after a preset time period since the start of charging, that is, the temperature of the battery pack is too low or too high, the interval SoH cannot be calculated during this charging process.

3. The health assessment reference value that matches the charge current exists. The battery pack may be coupled to different charging devices and charged by different charging devices. Different charging devices may have different charging logics, currents, and rates. Therefore, for the same battery pack, different actual charge capacities may be obtained in the same preset voltage interval when different charging devices are used. This difference is not caused by the SoH of the battery pack but by the difference in charging conditions. Therefore, when the battery pack is charged by different charging devices, different health assessment reference values need to be selected. In an example, multiple health assessment reference values are pre-stored in the battery pack. Since the charging devices cannot be exhaustively listed and different charging devices mainly differ in charge current, the charge current may be used as a search condition, thereby acquiring the health assessment reference value that matches the charge current during the current charging process. In an example, the charge current refers to the average charge current within the preset voltage interval. However, when the battery pack is connected to a new charging device, the charge current of the new charging device may be different from the pre-stored charge current. Therefore, the health assessment reference value that matches the charge current during this charging process cannot be found, and the interval SoH cannot be calculated during this charging process.

In S820, the overall SoH of the battery pack is determined according to the interval SoH and a preset mapping model.

During the production of the battery pack, a mapping model from the interval SoH to the overall SoH may be established through sampling tests, function fitting, and other manners, and the mapping model may be pre-stored in the battery pack or the charger. The present application does not limit the specific examples of the preset mapping model. In an example, the overall SoH may be a linear or nonlinear function of the interval SoH. In an example, the overall SoH may be acquired according to the interval SoH by a lookup table. In an example, the preset mapping model may be combined with parameters such as the resistance and voltage of the battery pack, thereby determining the overall SoH of the battery pack. In an example, before step S820 is performed, the difference between the interval SoH estimated in step S810 and the previous interval SoH needs to be verified. If the difference is too large, it is considered that the estimated value of the interval SoH is abnormal and is not adopted.

When the battery pack is connected to a new charging device and the health assessment reference value that matches the charge current during this charging process cannot be found, the battery pack can self-learn and store the health assessment reference value corresponding to the charge current so that the next time the charging device is used again, the health assessment reference value may be used to estimate the interval SoH of the battery pack. Specifically, the method for calculating the health assessment reference value includes: calculating the actual charge capacity of the battery pack within the preset voltage interval during the charging process of the battery pack; and calculating the health assessment reference value of the battery pack within the preset voltage interval according to the actual charge capacity and the interval SoH stored in the battery pack. The actual charge capacity may be calculated in an ampere-hour integral method. When a new charging device is used, assuming that the SoH of the battery pack does not change suddenly after this charging process, the interval SoH of the battery pack calculated last time is used as the basis to reversely calculate the health assessment reference value corresponding to the current charging device or the current charge current. The calculated health assessment reference value may be stored in the battery pack or the charging device.

The preceding method for evaluating the SoH of the battery pack 1 may be performed by the battery pack 1 or the charger 2'. Specifically, the method is performed by the first controller 12 of the battery pack 1 or the second controller 21' of the charger 2'. The detection assembly 11 may be disposed in at least one of the battery pack 1 and the charger 2'. The detection assembly 11 may include the voltage sensor, the current sensor, and the temperature sensor for detecting the voltage, charge current, and temperature of the battery pack 1; and pre-stored information such as the health assessment reference value and detected data such as the voltage and charge current may be transmitted from the battery pack 1 to the charger 2' or from the charger 2' to the battery pack 1, thereby performing the preceding evaluation method. In addition, the battery pack 1 or the charger 2' may include a display device for displaying the SOH of the battery pack 1 to the user. The display device may be disposed on the battery pack 1, the charger 2', or a mobile terminal such as a mobile phone so that the user can learn the aging state of the battery pack 1, thereby better maintaining the battery pack 1 or replacing the battery pack 1 in time.

This example further provides a method for reducing lithium plating in a battery pack. When the lithium-ion battery pack of the power tool is charged at a low temperature, a high current, or a high SoC, lithium metal is easily precipitated on the surface of the negative electrode material of the battery pack. In severe cases, dendritic lithium dendrites appear. The application of fast charging technology exacerbates this phenomenon, seriously affecting the service life and safety of the battery pack. Therefore, there is an urgent need for a technology through which the time point when lithium plating starts in the battery pack can be promptly detected and the charge power of the battery pack can be adjusted so that lithium plating can be reduced or eliminated under the premise of fast charging, thereby improving the service life and safety of the battery pack.

A method for reducing lithium plating in a battery pack provided in this example is described below. During the charging process of the battery pack, the charge current is reduced to a set value at intervals of a first set period and maintained for a second set period, and the change in current $\Delta I$ and the change in voltage $\Delta V$ of the battery pack during the reduction of the charge current are detected so that based on $\Delta I$ and $\Delta V$, the charge transfer impedance of the battery pack each time the current is reduced to the set value can be calculated. The calculated charge transfer impedance of the battery pack is compared with the charge transfer impedance in the charge transfer impedance table stored in the battery pack. When the calculated charge transfer impedance is less than the charge transfer impedance corresponding to the corresponding SoC in the stored charge transfer impedance table, the maximum charge current value allowed by the battery pack is reduced according to a first setting rule, and the charge transfer impedance table is updated.

The first set period may be set according to the charging state of the battery pack, for example, at least one of the charge temperature, the charge current, and the SoC of the battery pack. In some examples, the set period may be 60s.

The second set period and the set value may both be set according to the characteristics of the battery pack. Within the second set period, the current of the battery pack can reach the set value. In some examples, the second set period may be 1s. In some examples, the set value may be close to zero.

In some examples, the step of, based on $\Delta I$ and $\Delta V$, calculating the charge transfer impedance of the battery pack each time the current is reduced to the set value may include: according to a second formula, calculating the charge transfer impedance of the battery pack each time the current is reduced to the set value. The second formula is $Z = \Delta V/\Delta I$. Z denotes the charge transfer impedance of the battery pack.

The first setting rule may be determined according to actual situations. In some examples, the first setting rule is a fixed value, that is, the maximum charge current value allowed by the battery pack is reduced by the fixed value. In some examples, the first setting rule is a variable step size, that is, the maximum charge current value allowed by the battery pack is reduced by the variable step size. For example, when the degree to which the calculated charge transfer impedance is less than the charge transfer impedance corresponding to the corresponding SoC in the stored charge transfer impedance table is relatively small, the maximum charge current value allowed by the battery pack is reduced by a first step size; and when the degree to which the calculated charge transfer impedance is less than the charge transfer impedance corresponding to the corresponding SoC in the stored charge transfer impedance table is relatively large, the maximum charge current value allowed by the battery pack is reduced by a second step size, where the first step size is less than the second step size.

Another method for reducing lithium plating in a battery pack provided in this example is described below. During the charging process of the battery pack, the charge current is reduced to a set value at intervals of a first set period and maintained for a second set period, and the change in current $\Delta I$ and the change in voltage $\Delta V$ of the battery pack during the reduction of the charge current are detected so that based on $\Delta I$ and $\Delta V$, the charge transfer impedance of the battery pack each time the current is reduced to the set value can be calculated. The charge transfer impedance of the battery pack calculated at the current moment is compared with the charge transfer impedance of the battery pack calculated at the previous moment. If the charge transfer impedance of the battery pack calculated for three or more consecutive times is less than the charge transfer impedance of the battery pack calculated at the previous moment, the maximum charge current value allowed by the battery pack is reduced according to a second setting rule.

The second setting rule may be set according to actual situations. In some examples, the second setting rule is the same as the first setting rule. In some examples, the second setting rule is different from the first setting rule.

Another method for reducing lithium plating in a battery pack provided in this example is described below. During the charging process of the battery pack, the lithium plating in the battery pack is detected in real time, and when lithium plating in the battery pack is detected, the charge current of the battery pack is reduced according to a third setting rule until lithium plating in the battery pack is not detected.

A method for detecting lithium plating in a battery pack may include, but is not limited to, pulse charging detection, charge transfer impedance method, low current method, impedance-capacity method and voltage relaxation method.

The third setting rule may be set according to actual situations. In some examples, the third setting rule is a fixed value, that is, the charge current of the battery pack is reduced by the fixed value.

The basic principles, main features, and advantages of this application are shown and described above. It is to be understood by those skilled in the art that the aforementioned examples do not limit the present application in any form, and all technical solutions obtained through equivalent substitutions or equivalent transformations fall within the scope of the present application.

**Claims**

1. An electrical device system, comprising:
   a battery pack (1) comprising:

   > a housing (14);
   > a plurality of cells (15) accommodated in the housing (14);
   > a power tool interface (13) disposed on the housing (14); and
   > a first circuit board (16) accommodated in the housing (14) and electrically connected to the power tool interface (13), wherein a first controller (12) is disposed on the first circuit board (16);

   a body (2) comprising:

   > a body housing (24);
   > a battery pack interface (23) disposed on the body housing (24) and used for electrically and communicatively connecting the power tool interface (13); and
   > a second circuit board accommodated in the body housing (24) and electrically connected to the battery pack interface (23), wherein a second controller (21) is disposed on the second circuit board; and
a detection assembly (11) for detecting at least a voltage and a current of the battery pack (1), wherein the detection assembly (11) is disposed in the housing (14) of the battery pack (1) and/or the body housing (24) of the body (2);
wherein the first controller (12) or the second controller (21) is communicatively connected to the detection assembly (11) and is configured to:

acquire the voltage and the current of the battery pack (1) through the detection assembly (11);
calculate a current depth of discharge (DoD) of the battery pack (1) based on the voltage and the current of the battery pack (1);
determine an endpoint DoD of the battery pack (1) in a current working condition based on the voltage, the current, and the current DoD of the battery pack (1); and
determine a state of charge (SoC) of the battery pack and a relative SoC (RSoC) of the battery pack in the current working condition according to the current DoD and the endpoint DoD.

2. The electrical device system of claim 1, wherein the RSoC is a ratio of a difference between the endpoint DoD and the current DoD to the endpoint DoD, and the SoC is a difference between 1 and the current DoD.

3. The electrical device system of claim 1, wherein determining the current DoD of the battery pack (1) comprises: calculating an initial DoD based on a voltage of the battery pack (1) at rest and calculating the current DoD based on the initial DoD, a maximum chemical capacity, and the current of the battery pack (1).

4. The electrical device system of claim 3, wherein the maximum chemical capacity is determined based on an initial chemical capacity and an overall state of health (SoH) of the battery pack (1).

5. The electrical device system of claim 2, wherein a moment when the voltage of the battery pack (1) reaches a discharge cut-off voltage is defined as a discharge endpoint, and the endpoint DoD is defined as a DoD corresponding to the voltage at the discharge endpoint.

6. The electrical device system of claim 5, wherein determining the endpoint DoD of the battery pack (1) in the current working condition based on the voltage, the current, and the current DoD of the battery pack (1) comprises: adaptively learning an impedance curve in the current working condition based on the voltage, the current, and the current DoD of the battery pack (1); determining a voltage variation curve of the battery pack (1) in the current working condition according to the impedance curve and the current DoD; and determining the endpoint DoD according to the voltage variation curve and the discharge cut-off voltage.

7. The electrical device system of claim 6, wherein the detection assembly (11) further comprises a temperature sensor for acquiring temperature information of the battery pack (1); wherein adaptively learning the impedance curve in the current working condition based on the voltage, the current, and the current DoD of the battery pack (1) comprises: based on the voltage and the current of the battery pack (1), calculating impedance information of the battery pack (1) corresponding to the current DoD; and updating the impedance curve based on the impedance information and the temperature information.

8. The electrical device system of claim 7, wherein updating the impedance curve based on the impedance information and the temperature information comprises:

performing linear regression on the impedance information to obtain corrected impedance; calculating normalized impedance based on the corrected impedance and the temperature information; and updating the impedance curve according to a difference between the normalized impedance and impedance corresponding to the current DoD in the impedance curve.

9. The electrical device system of claim 4, wherein the overall SoH is determined according to an interval SoH of the battery pack (1).

10. A method for estimating a relative state of charge (RSoC) of a battery pack (1), wherein the battery pack (1) comprises a housing (14), a plurality of cells (15) accommodated in the housing (14), a power tool interface (13) disposed on the housing (14), and a first circuit board (16) accommodated in the housing (14) and electrically connected to the power tool interface (13), wherein a first controller (12) is disposed on the first circuit board (16); wherein the estimation method comprises:

acquiring a voltage and a current of the battery pack (1) through a detection assembly (11); determining a current depth of discharge (DoD) of the battery pack (1) based on the voltage and the current of the battery pack (1); determining an endpoint DoD of the battery pack (1) in a current working condition based on the voltage, the current, and the current DoD of the battery pack (1); and calculating the RSoC of the battery pack (1) in the current working condition according to the current DoD and the endpoint DoD.

11. The estimation method of claim 10, wherein determining the current DoD of the battery pack (1) based on the voltage and the current of the battery pack (1) comprises:

calculating an initial DoD based on the voltage of the battery pack (1) at rest and calculating the current DoD based on the initial DoD, a maximum chemical capacity, and the current of the battery pack (1).

12. The estimation method of claim 10, wherein a moment when the voltage of the battery pack (1) reaches a discharge cut-off voltage is defined as a discharge endpoint, and the endpoint DoD is defined as a DoD corresponding to the voltage at the discharge endpoint.

13. The estimation method of claim 12, wherein determining the endpoint DoD of the battery pack (1) in the current working condition based on the voltage, the current, and the current DoD of the battery pack (1) comprises: adaptively learning an impedance curve in the current working condition based on the voltage, the current, and the current DoD of the battery pack (1); determining a voltage variation curve of the battery pack (1) in the current working condition according to the impedance curve and the current DoD; and determining the endpoint DoD according to the voltage variation curve and the discharge cut-off voltage.

14. The estimation method of claim 13, wherein adaptively learning the impedance curve in the current working condition based on the voltage, the current, and the current DoD of the battery pack (1) comprises: based on the voltage and the current of the battery pack (1), calculating impedance information of the battery pack (1) corresponding to the current DoD; and updating the impedance curve based on the impedance information and temperature information.

15. The estimation method of claim 10, wherein the RSoC is a ratio of a difference between the endpoint DoD and the current DoD to the endpoint DoD.

Calculate the DoD of the battery pack in real time based on the data acquired by a voltage sensor and a current sensor
S110

Determine a voltage variation curve of the battery pack based on the impedance curve and the DoD of the battery pack
S120

Determine the DoD of the battery pack at the charge/discharge endpoint according to the voltage variation curve and the charge/discharge cut-off voltage of the battery pack
S130

Calculate the charging/discharging completion time of the battery pack according to the DoD at the charge/discharge endpoint and the DoD at the current moment
S140

FIG. 1

FIG. 2

Determine the initial DoD based on the voltage information of the battery pack at rest acquired by a voltage sensor    S210

Calculate the DoD at the current moment based on the initial DoD, the maximum chemical capacity of the battery pack, and the data acquired by a current sensor    S220

Use the DoD at the current moment as a starting point, simulate and calculate the voltage of the battery pack in a variable step-size stepping manner, and generate the voltage variation curve    S230

During the charging process of the battery pack, use the DoD corresponding to the charge cut-off voltage in the voltage variation curve as the DoD of the battery pack at the charge endpoint; during the discharging process of the battery pack, use the DoD corresponding to the discharge cut-off voltage in the voltage variation curve as the DoD of the battery pack at the discharge endpoint    S240

Calculate the charging/discharging completion time of the battery pack according to the first calculation formula    S250

FIG. 3

410

420

430

440

| DoD determination module | Voltage variation curve determination module | Charge/discharge endpoint determination module | Charging/ discharging completion time determination module |

FIG. 4

Calculate the DoD of the battery pack in real time based on the data acquired by a voltage sensor and a current sensor — S310

Calculate the impedance information of the battery pack in real time based on the data acquired by the voltage sensor and the current sensor — S320

Determine the temperature information of the battery pack based on the data acquired by a temperature sensor — S330

Based on the impedance information and temperature information acquired in real time, update the impedance curve of the battery pack — S340

Determine a voltage variation curve of the battery pack based on the impedance curve and the DoD of the battery pack — S350

Determine the DoD of the battery pack at the charge/discharge endpoint according to the voltage variation curve and the charge/discharge cut-off voltage of the battery pack — S360

Update the maximum chemical capacity of the battery pack according to the current data and the DoD — S370

Calculate the charging/discharging completion time of the battery pack according to the first calculation formula — S380

FIG. 5

FIG. 6

FIG. 7

FIG. 8A

FIG. 8B

FIG. 8C

FIG. 9

FIG. 10

Acquire the state parameter of the battery pack — S510

Calculate the SoC of the battery pack according to the current information and the voltage information — S520

Determine the instantaneous DC resistance and/or continuous DC resistance of the battery pack according to the SoC and temperature information of the battery pack — S530

Determine the instantaneous voltage before discharge and the continuous voltage before discharge of the battery pack according to the current information — S540

S550
Determine whether the instantaneous voltage before discharge or the continuous voltage before discharge is lower than the cut-off voltage

Y

N

Stop discharging the battery pack after a preset time period according to the current information. — S560

Determine a first discharge capability parameter according to the instantaneous voltage before discharge, the cut-off condition, and the instantaneous DC resistance of the battery pack; and/or determine a second discharge capability parameter according to the continuous voltage before discharge, the cut-off condition, and the continuous DC resistance — S570

Perform current limiting protection on the battery pack according to the temperature parameter and the discharge capability parameter — S580

FIG. 11

Acquire the state parameter of the battery pack — S610

Determine a first reference value of the discharge capability parameter based on the voltage constraint — S620

Determine a second reference value of the discharge capability parameter based on the DoD constraint — S630

Determine a third reference value of the discharge capability parameter based on the first reference value and the second reference value — S640

Determine the discharge capability parameter by limiting the third reference value based on temperature — S650

FIG. 12

Acquire the state parameter of the battery pack through a detection assembly — S710

Determine the discharge capability parameter according to the state parameter — S720

Limit the discharge of the battery pack according to the discharge capability parameter, and then reacquire the voltage of the battery pack — S730

Update the discharge capability parameter according to the difference between the reacquired voltage and the cut-off voltage of the battery pack — S740

FIG. 13

FIG. 14

FIG. 15

FIG. 16

1

16

13

14

15

FIG. 17

1

2'

FIG. 18

FIG. 19

| Estimate the interval SoH of the battery pack within a preset voltage interval during the charging process of the battery pack | S810 |

| Determine the overall SoH of the battery pack according to the interval SoH and a preset mapping model | S820 |

FIG. 20

FIG. 21

FIG. 22

Europäisches Patentamt

European Patent Office

Office européen des brevets

# EUROPEAN SEARCH REPORT

**Application Number**

EP 24 21 9636

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/050393 A1 (STROUD ADAM B [US] ET AL) 16 February 2023 (2023-02-16) <br> * paragraphs [0089] - [0094], [0129] - [0135], [0155], [0163] * <br> * figures 1A, 1B, 2A, 3, 4, 15 * <br> - - - - - | 1-15 | INV. <br> H01M10/42 <br> G01R31/327 <br> H01M10/623 |
| Y | US 2015/066407 A1 (JOE WON-TAE [KR] ET AL) 5 March 2015 (2015-03-05) <br> * the whole document * * <br> * in particular: * <br> * paragraphs [0187], [0142], [0143]; figure 6 * <br> - - - - - | 1-15 | |
| A | US 11 374 425 B2 (HITACHI AUTOMOTIVE SYSTEMS LTD [JP]; VEHICLE ENERGY JAPAN INC [JP]) 28 June 2022 (2022-06-28) <br> * abstract *; figure 1 * <br> - - - - - | 1-15 | |
| A | US 2020/301696 A1 (YANG DEZHONG [CN] ET AL) 24 September 2020 (2020-09-24) <br> * abstract *; figure 1 * <br> - - - - - | 1-15 | **TECHNICAL FIELDS SEARCHED (IPC)** <br> H01M <br> G01R |

The present search report has been drawn up for all claims

| Place of search | Date of completion of the search | Examiner |
|---|---|---|
| The Hague | 2 June 2025 | Standaert, Frans |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .............................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 9636

This annex lists the patent family members relating to the patent documents cited in the above-mentioned European search report.
The members are as contained in the European Patent Office EDP file on
The European Patent Office is in no way liable for these particulars which are merely given for the purpose of information.

02-06-2025

| Patent document cited in search report | Publication date | Patent family member(s) | | Publication date |
|---|---|---|---|---|
| US 2023050393 A1 | 16-02-2023 | AU | 2021231693 A1 | 18-08-2022 |
| | | CN | 115210946 A | 18-10-2022 |
| | | EP | 4115472 A2 | 11-01-2023 |
| | | US | 2023050393 A1 | 16-02-2023 |
| | | WO | 2021178196 A2 | 10-09-2021 |
| US 2015066407 A1 | 05-03-2015 | CN | 104395771 A | 04-03-2015 |
| | | EP | 2837944 A1 | 18-02-2015 |
| | | JP | 5946955 B2 | 06-07-2016 |
| | | JP | 2015523547 A | 13-08-2015 |
| | | KR | 20130122543 A | 07-11-2013 |
| | | PL | 2837944 T3 | 31-10-2019 |
| | | US | 2015066407 A1 | 05-03-2015 |
| | | WO | 2013165089 A1 | 07-11-2013 |
| US 11374425 B2 | 28-06-2022 | CN | 110447156 A | 12-11-2019 |
| | | EP | 3605779 A1 | 05-02-2020 |
| | | JP | 6863795 B2 | 21-04-2021 |
| | | JP | 2018170167 A | 01-11-2018 |
| | | US | 2019207406 A1 | 04-07-2019 |
| | | WO | 2018179854 A1 | 04-10-2018 |
| US 2020301696 A1 | 24-09-2020 | US | 2020301696 A1 | 24-09-2020 |
| | | US | 2021286612 A1 | 16-09-2021 |
| | | US | 2023127497 A1 | 27-04-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410455102
- CN 202411507849
- CN 202411507861
- CN 202411509221
- CN 202411504843